(19) Europäisches Patentamt

European Patent Office

Office européen des brevets

(11) **EP 2 330 825 A1**

(12) **EUROPEAN PATENT APPLICATION**
published in accordance with Art. 153(4) EPC

(43) Date of publication:
08.06.2011 Bulletin 2011/23

(21) Application number: **09815795.1**

(22) Date of filing: **29.06.2009**

(51) Int Cl.:
*H04N 7/26* (2006.01)    *H03M 7/42* (2006.01)

(86) International application number:
**PCT/JP2009/002976**

(87) International publication number:
**WO 2010/035373 (01.04.2010 Gazette 2010/13)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **25.09.2008 JP 2008245329**
**26.05.2009 JP 2009126183**

(71) Applicant: **Renesas Electronics Corporation Kanagawa 211-8668 (JP)**

(72) Inventors:
• **NAKAMURA, Katsuyuki**
**Yokohama-shi**
**Kanagawa 244-0817 (JP)**

• **YOKOYAMA, Toru**
**Yokohama-shi**
**Kanagawa 244-0817 (JP)**
• **TAKAHASHI, Masashi**
**Yokohama-shi**
**Kanagawa 244-0817 (JP)**

(74) Representative: **Calderbank, Thomas Roger**
**Mewburn Ellis LLP**
**33 Gutter Lane**
**London**
**EC2V 8AS (GB)**

(54) **IMAGE DECODING METHOD AND IMAGE CODING METHOD**

(57)    The present invention is directed to improve compression efficiency by variable-length coding in accordance with characteristics of image data to be processed. An apparatus for compressing quantized data by variable-length coding includes: a statistical information storing memory (212) for storing statistical information (MBTyp and CBPL) of coded image data; a variable-length code table generating unit (213) for generating a variable-length code table on the basis of the statistical information stored in the memory; and a variable-length coding unit (205) for performing variable-length coding on the basis of the variable-length code table. The variable-length code table generating unit generates a variable-length code table by adding occurrence probability of statistical information calculated within a predetermined range of the coded image data and initial occurrence probability selected on the basis of a coding parameter (S3005), and assigning a short code in descending order of statistical information obtained by the addition (S3006).

Fig.1

**Description**

TECHNICAL FIELD

The present invention relates to a method of coding/decoding an image and an apparatus to which the method is applied.

BACKGROUND ART

Variable-length coding (entropy coding) to image data is a method for shortening average code length by, at the time of assigning a code to quantized data, assigning a short code for a value of high appearance value and assigning a long code to a code of low appearance frequency to thereby increase the compression rate.
In the H.264/AVC standard, as the entropy coding method, CAVLC (Context-Adaptive Variable-Length Coding) and CABAC (Context-Adaptive Binary Arithmetic Coding) are employed. The CAVLC is a technique for switching a variable-length code table used for coding a present macro block in accordance with the state of a DCT (Discrete Cosine Transform) coefficient of an adjacent macro block. The CABAC is a technique for coding a binary signal by using arithmetic coding.
However, in those techniques, a code is not always assigned in consideration of information generation probability. For example, in the H.264/AVC standard, a mode number of a variable length code to a macroblock type (MB type) is fixedly defined in advance, and variable length coding of the MB type is performed using a table (code table) in which the definition is reflected. The occurrence probability of the MB type, however, largely changes according to the size of an image, the state of a quantization parameter, and the like. There is a case such that a short code is assigned to an MB type which appears rarely or a long code is assigned to an MB type which appears frequently. Therefore, the compression rate cannot be always increased only by a defined code table. This problem occurs not only in the MB type but also in a CBP (Coded Block Pattern) parameter indicating whether an MB has a nonzero DCT coefficient or not.
One of methods which can be applied to such a problem is a method of adaptively generating a code table in accordance with situations, not using a fixed variable-length code table. For example, patent document 1 proposes a method of obtaining probability of occurrence of information such as a motion vector on a predetermined data unit of image data, adaptively generating a code table on the basis of the obtained occurrence probability, variable-length coding an image of the next predetermined data unit, and transmitting the coded image. Patent document 2 also discloses a coding/decoding technique of assigning a variable-length code on the basis of the occurrence probability.

[Prior Art Document]

[Patent Document]

[Patent Document 1] Japanese patent laid-open No. Hei 08(1996)-205169
[Patent Document 2] Japanese patent laid-open No. Hei 10 (1998) - 322222

DISCLOSURE OF THE INVENTION

PROBLEMS THAT THE INVENTION IS TO SOLVE

However, in the techniques described in the patent documents 1 and 2, sufficient statistics length is not obtained at the initial stage of coding or immediately after resetting the occurrence probability, and high coding efficiency cannot be always achieved. Since the occurrence probability of information is obtained on the frame unit basis, the reliability of a communication path is low. When an information deficiency occurs, decoding becomes unable to be performed at that time point. The inventors of the present invention clarified problems such that, since a variable-length code table to be used in a next frame is generated on the basis of the occurrence probability of information in a preceding frame, in the case of a motion image having low correlation between frames, for example, a motion image having a dramatic movement, the coding efficiency deteriorates. Further, the inventors of the present invention found out that, from the viewpoint of improving compression efficiency, it is important to how to determine a reference range for obtaining the occurrence probability.
An object of the present invention is to provide a coding technique realizing improvement in compression efficiency of variable-length coding in accordance with characteristics of image data to be processed and a decoding technique corresponding to the coding technique.

A concrete object of the present invention is to provide a coding technique realizing improvement in compression efficiency of variable-length coding even when there is no sufficient statistics length and a decoding technique corresponding to the coding technique.

Another concrete object of the present invention is to provide a coding technique realizing improvement in compression efficiency of variable-length coding in the case where information deficiency occurs or for an image having a large change and a decoding technique corresponding to the coding technique.

The above and other objects and novel features of the present invention will become apparent from the description of the specification and appended drawings.

MEANS FOR SOLVING THE PROBLEMS

Outline of representative one of inventions disclosed in the present application will be briefly described as follows.

In an image coding method, occurrence probability of statistical information calculated in a predetermined range of coded image data and initial occurrence probability selected on the basis of a coding parameter are added, and a short code is assigned in descending order of statistical information of high occurrence probability obtained by the addition, thereby generating a variable-length code table. On the basis of the generated variable-length code table, variable-length coding is performed. In an image decoding method, occurrence probability of statistical information calculated in a predetermined range of decoded image data and initial occurrence probability selected on the basis of a decoding parameter are added, and a short code is assigned in descending order of statistical information of high occurrence probability obtained by the addition, thereby generating a variable-length decode table. On the basis of the generated variable-length decode table, variable-length decoding is performed.

EFFECTS OF THE INVENTION

Effects obtained by the representative one of the inventions disclosed in the application will be briefly described as follows.

That is, according to the image coding method of the present invention, the compression efficiency of variable-length coding can be improved according to the characteristics of image data to be processed. According to the image decoding method of the present invention, decoding on data coded by the image coding method according to the present invention can be realized.

BRIEF DESCRIPTION OF THE DRAWINGS

FIG. 1 is a block diagram of an image coding apparatus according to a first embodiment of the present invention.
FIG. 2 is an explanatory diagram on a variable-length code table according to a comparative example in which a macroblock type and a mode number are fixed and the mode number is not assigned in consideration of actual appearance frequency.
FIG. 3 is an operation flowchart of a variable-length code table generating unit in the image coding apparatus of FIG. 1.
FIG. 4 is an explanatory diagram of an initial histogram.
FIG. 5A is an explanatory diagram showing an example of a reference range at the time of calculating a frequency distribution of an MB type in a peripheral block.
FIG. 5B is an explanatory diagram showing an example of a frequency distribution in a reference range.
FIG. 6 is an explanatory diagram of a reference range (slice unit).
FIG. 7 is an explanatory diagram of a reference range (picture unit).
FIG. 8 is an explanatory diagram of a reference range (sequence unit).
FIG. 9 is an explanatory diagram on setting of a reference range according to the first embodiment of the invention.
FIG. 10 is an explanatory diagram showing a variable-length code table of an MB type generated by the image coding apparatus of FIG. 1.
FIG. 11 is a functional block diagram of an image decoding apparatus according to the first embodiment of the invention.
FIG. 12 is an explanatory diagram of a variable-length code table of CodedBlockPatternLuma generated in the first embodiment of the invention.
FIG. 13A is an explanatory diagram showing example 1 of setting a reference range in a second embodiment of the invention.
FIG. 13B is an explanatory diagram showing example 2 of setting a reference range in the second embodiment of the invention.

FIG. 13C is an explanatory diagram showing example 3 of setting the reference range in the second embodiment of the invention.

FIG. 14 is a flowchart of a variable-length code table generating unit according to the second embodiment of the invention.

FIG. 15 is an explanatory diagram on setting of a reference range according to a third embodiment of the invention.

FIG. 16 is a block diagram of another image coding apparatus according to the first embodiment of the invention.

FIG. 17 is an explanatory diagram of a variable-length code table in which the MB type and CodedBlockPatternLuma generated in the first embodiment of the invention.

FIG. 18 is an operation flowchart of a variable-length code table generating unit according to the third embodiment of the invention.

FIG. 19 is an explanatory diagram of selection of a code table according to the first embodiment of the invention.

FIG. 20 is a flowchart illustrating processes performed by the variable-length code table generating unit for adaptively selecting a reference range or performing weighting on the basis of the degree of similarity of histograms of two regions according to a fourth embodiment of the invention.

FIG. 21 is an explanatory diagram of concept on determination of the degree of similarity of histograms of two regions in the process of FIG. 20.

FIG. 22 is a flowchart illustrating a procedure obtained by adding a procedure using the initial histogram explained with reference to FIG. 3 to the process of FIG. 20.

FIG. 23 is a flowchart showing processes performed by the variable-length code table generating unit for adaptively selecting a reference range or performing weighting on the basis of a representative value of a motion vector according to a fifth embodiment of the invention.

FIG. 24 is an explanatory diagram illustrating concept of a correcting process performed by the variable-length code table generating unit for correcting a reference range by a representative value of a motion vector in an arbitrary region according to a sixth embodiment of the invention.

FIG. 25 is an explanatory diagram illustrating the correct answer rate as a result of the variable-length coding performed using specific blocks as a reference range on the basis of a result of variable-length coding in past decoded frames according to a seventh embodiment of the invention.

BEST MODE FOR CARRYING OUT THE INVENTION

1. Summary of the embodiments

First, summary of representative embodiments of the invention disclosed in the application will be described. Reference numerals in the diagrams which are referred to in parentheses in explanation of the summary of the representative embodiments just illustrate objects included in the concept of components to which the reference numerals are designated.

[1] Addition and updating of occurrence probability (decoding method)
An image decoding method according to a representative embodiment of the present invention is a method of decoding data which is variable-length coded, and includes: a first process of storing statistical information of decoded image data into a memory; a second process of generating a variable-length decode table on the basis of the statistical information stored in the memory; and a third process of performing variable-length decoding on the basis of the variable-length decode table generated in the second process. The second process is a process of generating a variable-length decode table by adding occurrence probability of statistical information calculated within a predetermined range of the decoded image data and initial occurrence probability selected on the basis of a decoding parameter, and assigning a short code in descending order of statistical information obtained by the addition. By the method, the variable-length decode table can be updated according to the characteristics of image data to be processed, and it can contribute to improvement in the compression efficiency of the variable-length coding from the aspect of the decoding process.

[2] In the image decoding method of [1], in the variable-length decode table generating process, the occurrence probability is generated by adding a weight according to the degree of influence on an object to be decoded, to information calculated in the predetermined range of the coded image data. It can contribute to further improvement in compression rate.

[3] In the image decoding method of [1], for example, the statistical information is of a macro block type or is a coded block pattern parameter.

[4] In the image decoding method of [1], for example, in the variable-length decode table generating process, a reference range specified by a syntax element in stream information to be decoded is set to a range of image data for calculating occurrence probability of the statistical information. Consequently, in the case where information deficiency occurs or also for an image having a large change, in a manner similar to the above, the method can contribute to improvement in compression efficiency of the variable-length coding from the aspect of the decoding process.

[5] In the image decoding method of [1], for example, in the variable-length decode table generating process, whether statistical information which can be referred to at the time of calculating the occurrence probability of the statistical information satisfies preliminarily-set statistics length or not is determined, when the statistics length is not satisfied, a predetermined variable-length decode table is selected and set to be usable and, when the statistics length is satisfied, a variable-length decode table is generated on the basis of the occurrence probability of the statistical information calculated in the predetermined range. Consequently, even when there is no sufficient statistics length, in a manner similar to the above, the method can contribute to improvement in compression efficiency of the variable-length coding from the aspect of the decoding process.

[6] Selection of Code in Variable-Length Decode Table (Decoding Method)

An image decoding method according to a representative embodiment of the invention is an image decoding method of decoding data which is variable-length coded, and includes: a first process of storing statistical information of decoded image data into a memory; a second process of generating a variable-length decode table on the basis of the statistical information stored in the memory; and a third process of performing variable-length decoding on the basis of the variable-length decode table generated in the second process. The second process is a process of generating a variable-length decode table by selecting a code used for a variable-length decode table in accordance with the proportion of statistical information of high occurrence probability on entire statistical information calculated within a predetermined range of the decoded image data and assigning a short code in descending order of the calculated statistical information of the high occurrence probability. In the case of generating a variable-length decode table on the basis of the occurrence probability of the statistical information, a code used for the variable-length decode table can be selected. Consequently, the method can contribute to further improvement in compression efficiency of the variable-length coding from the aspect of the decoding process in accordance with the parameter of a code selected.

[7] Use of Initial Variable-Length Decode Table when Statistics Length is Small (Decoding Method)

An image decoding method according to a representative embodiment of the invention is a method of decoding data which is variable-length coded, and includes: a first process of storing statistical information of decoded image data into a memory; a second process of generating a variable-length decode table on the basis of the statistical information stored in the memory; and a third process of performing variable-length decoding on the basis of the variable-length decode table generated in the second process. The second process is a process of generating a variable-length decode table by determining whether or not statistical information which can be referred to at the time of calculating occurrence probability of statistical information satisfies preliminarily-set statistics length or not, when the statistics length is not satisfied, selecting a predetermined variable-length decode table and setting it to be usable and, when the statistics length is satisfied, assigning a short code in descending order of the calculated statistical information of the high occurrence probability on the basis of the occurrence probability of the statistical information calculated within a predetermined range. The method can contribute to improvement in compression efficiency of the variable-length coding from the aspect of the decoding process even when there is no sufficient statistics length.

[8] Determination of Reference Range according to the Degree of Similarity of Histograms (Decoding Method)

An image decoding method according to a representative embodiment of the present invention is a method of decoding data which is variable-length coded, and includes: a first process of storing statistical information of decoded image data into a memory; a second process of generating a variable-length decode table on the basis of the statistical information stored in the memory; and a third process of performing variable-length decoding on the basis of the variable-length decode table generated in the second process. The second process is a process of determining the degree of similarity of histograms on occurrence probability of statistical information calculated in a plurality of positions in decoded image data, determining a predetermined range for calculating the occurrence probability in accordance with the degree of similarity, and generating a variable-length decode table on the basis of the occurrence probability of the statistical information calculated in the determined predetermined range. Since the reference range can be determined according to the degree of similarity, also from this viewpoint, the method can contribute to improvement in compression efficiency of the variable-length coding from the aspect of the decoding process.

[9] Reference To Present Frame At Low Degree of Similarity, and Reference To Past/Future Frame At High Degree of Similarity (Decoding Method)

In the image decoding method of [8], for example, in the second process, when the degree of similarity of the histograms is smaller than a threshold, a predetermined range for calculating occurrence probability is determined in a present frame and, when the degree of similarity of the histograms is larger than a threshold, a predetermined range for calculating the occurrence probability is determined in a past or future frame. This is one mode realizing improved compression rate.

[10] Addition and Updating of Occurrence Probability (Decoding Method)
In the image decoding method of [8], for example, the second process is a process of generating a variable-length decode table by adding occurrence probability of statistical information calculated in the determined predetermined range of decoded image data and initial occurrence probability selected on the basis of a decode parameter, and assigning a short code in descending order of statistical information of high occurrence probability obtained by the addition.

[11] Determination of Reference Range according to the Motion Vector (Decoding Method)
An image decoding method according to a representative embodiment of the invention is a method of decoding data which is variable-length coded and includes: a first process of storing statistical information of decoded image data into a memory; a second process of generating a variable-length decode table on the basis of the statistical information stored in the memory; and a third process of performing variable-length decoding on the basis of the variable-length decode table generated in the second process. The second process is a process of generating a variable-length decode table by generating a motion vector in a predetermined range of a block to be decoded in a present frame of the decoded image data, determining a predetermined range for calculating occurrence probability on the basis of the generated motion vector, and assigning a short code in descending order of statistical information of the occurrence probability of the statistical information in the predetermined range. In such a manner, the reference range can be determined according to the motion vector, also from the viewpoint, the method can contribute to improvement in compression efficiency of the variable-length coding from the aspect of the decoding process.

[12] In the image decoding method of [11], in the second process, when the generated motion vector is larger than a threshold, a variable-length decode table is generated by assigning a short code in descending order of statistical information of high occurrence probability of the statistical information in the predetermined range in a present frame and, when the generated motion vector is smaller than a threshold, a variable-length decode table is generated by assigning a short code in descending order of statistical information of high occurrence probability in a predetermined range in a past or future frame.

[13] In the image decoding method of [12], in the second process, when the generated motion vector is smaller than a threshold, by correcting a predetermined range in a past or future frame by the generated motion vector and assigning a short code in descending order of statistical information of high occurrence probability of the statistical information in the corrected predetermined range, a variable-length decode table is generated. This is one mode of realizing improvement in compression rate.

[14] Determination of Reference Range by Actual Performance of Variable-Length Coding (Decoding Method)
An image decoding method according to a representative embodiment of the invention is a method of decoding data which is variable-length coded, and includes: a first process of storing statistical information of decoded image data into a memory; a second process of generating a variable-length decode table on the basis of the statistical information stored in the memory; and a third process of performing variable-length decoding on the basis of the variable-length decode table generated in the second process. The second process is a process of generating a variable-length decode table by assigning a short code in descending order of statistical information of the occurrence probability of the statistical information in the predetermined range in which the number of bits of a code to be variable-length decoded in a past frame is predetermined number of bits or less. Since the reference range is determined in response to a range of high compression rate by actual performance of the variable-length coding, in a manner similar to the above, the method can contribute to improvement in the compression efficiency of the variable-length coding from the aspect of the decoding process.

[15] Addition and Updating of Occurrence Probability (Decoding Apparatus)
An image decoding apparatus according to a representative embodiment of the invention is an apparatus for decoding data which is variable-length coded, and includes: a memory for storing statistical information of decoded image data; a variable-length decode table generating unit for generating a variable-length decode table on the basis of the statistical information stored in the memory; and a variable-length decoding unit for performing variable-length decoding on the basis of the variable-length decode table generated by the variable-length decode table generating unit. The variable-length decode table generating unit generates a variable-length decode table by adding occurrence probability of statistical information calculated within a predetermined range of the decoded image data and initial occurrence probability selected on the basis of a decoding parameter, and assigning a short code in descending order of statistical information obtained by the addition.

[16] Selection of Code in Variable-Length Decode Table (Decoding Apparatus)
An image decoding apparatus according to another representative embodiment of the invention is an apparatus of decoding data which is variable-length coded, and includes: a memory for storing statistical information of decoded image data; a variable-length decode table generating unit for generating a variable-length decode table on the basis of the statistical information stored in the memory; and a variable-length decoding unit for performing variable-length decoding on the basis of the variable-length decode table generated by the variable-length decode table generating unit. The variable-length decode table generating unit generates a variable-length decode table by selecting a code used for a variable-length decode table in accordance with the proportion of statistical information of high occurrence probability on statistical information calculated within a predetermined range of the decoded image data and assigning a short code in descending order of the calculated statistical information of the high occurrence probability.

[17] Use of Initial Variable-Length Decode Table When Statistics Length Is Small (Decoding Apparatus)

An image decoding apparatus according to another representative embodiment of the invention is an apparatus for decoding data which is variable-length coded, and includes: a memory for storing statistical information of decoded image data; a variable-length decode table generating unit for generating a variable-length decode table on the basis of the statistical information stored in the memory; and a variable-length decoding unit for performing variable-length decoding on the basis of the variable-length decode table generated by the variable-length decode table generating unit. The variable-length decode table generating unit determines whether or not statistical information which can be referred to at the time of calculating occurrence probability of statistical information satisfies preliminarily-set statistics length, when the statistics length is not satisfied, selects a predetermined variable-length decode table and sets it to be usable and, when the statistics length is satisfied, assigns a short code in descending order of the statistical information of the high occurrence probability on the basis of the occurrence probability of the statistical information calculated in a predetermined range.

[18] Determination of Reference Range by Degree of Similarity of Histograms (Decoding Apparatus)

An image decoding apparatus according to another representative embodiment of the invention is an apparatus for decoding data which is variable-length coded, and includes: a memory for storing statistical information of decoded image data; a variable-length decode table generating unit for generating a variable-length decode table on the basis of the statistical information stored in the memory; and a variable-length decoding unit for performing variable-length decoding on the basis of the variable-length decode table generated by the variable-length decode table generating unit. The variable-length decode table generating unit determines the degree of similarity of histograms on occurrence probability of statistical information calculated in a plurality of positions in decoded image data, determines a predetermined range for calculating the occurrence probability in accordance with the degree of similarity, and generates a variable-length decode table on the basis of the occurrence probability of the statistical information calculated in the determined predetermined range.

[19] Reference To Present Frame At Low Degree of Similarity, and Reference To Past/Future Frame At High Degree of Similarity (Decoding Apparatus)

In the image decoding apparatus of [18], for example, when the degree of similarity of the histograms is smaller than a threshold, the variable-length decode table generating unit determines a predetermined range for calculating occurrence probability in a present frame. When the degree of similarity of the histograms is larger than a threshold, the variable-length decode table generating unit determines a predetermined range for calculating the occurrence probability in a past or future frame.

[20] Addition and Updating of Occurrence Probability (Decoding Apparatus)

In the image decoding apparatus of [18], for example, the variable-length decode table generating unit generates a variable-length decode table by adding occurrence probability of statistical information calculated in the determined predetermined range of decoded image data and initial occurrence probability selected on the basis of a decode parameter, and assigning a short code in descending order of statistical information of high occurrence probability obtained by the addition.

[21] Determination of Reference Range By Motion Vector (Decoding Apparatus)

An image decoding apparatus according to another representative embodiment of the invention is an apparatus for decoding data which is variable-length coded, and includes: a memory for storing statistical information of decoded image data; a variable-length decode table generating unit for generating a variable-length decode table on the basis of the statistical information stored in the memory; and a variable-length decoding unit for performing variable-length decoding on the basis of the variable-length decode table generated by the variable-length decode table generating unit. The variable-length decode table generating unit generates a variable-length decode table by generating a motion vector in a predetermined range of a block to be decoded in a present frame of the decoded image data, determining a predetermined range for calculating occurrence probability on the basis of the generated motion vector, and assigning a short code in descending order of statistical information of the occurrence probability of the statistical information in the predetermined range.

[22] In the image decoding apparatus of [18], for example, when the generated motion vector is larger than a threshold, the variable-length decode table generating unit generates a variable-length decode table by assigning a short code in descending order of statistical information of high occurrence probability of the statistical information in the predetermined range in a present frame. When the generated motion vector is smaller than a threshold, the variable-length decode table generating unit generates a variable-length decode table by assigning a short code in descending order of statistical information of high occurrence probability in a predetermined range in a past or future frame.

[23] In the image decoding apparatus of [19], for example, when the generated motion vector is smaller than a threshold, the variable-length decode table generating unit corrects a predetermined range in a past or future frame by the generated motion vector and assigns a short code in descending order of statistical information of high occurrence probability of the statistical information in the corrected predetermined range, thereby generating a variable-length decode table.

[24] Determination of Reference Range by Actual Performance of Variable-Length Coding (Decoding Apparatus)

An image decoding apparatus according to another representative embodiment of the invention is an apparatus for decoding data which is variable-length coded, and includes: a memory for storing statistical information of decoded image data; a variable-length decode table generating unit for generating a variable-length decode table on the basis of the statistical information stored in the memory; and a variable-length decoding unit for performing variable-length decoding on the basis of the variable-length decode table generated by the second process. The variable-length decode table generating unit generates a variable-length decode table by setting a range in which the number of bits of a code to be variable-length decoded in a past frame is predetermined number of bits or less as the predetermined range and assigning a short code in descending order of statistical information of the occurrence probability of the statistical information calculated in the predetermined range.

[25] Addition and Updating of Occurrence Probability (Decoding Method)

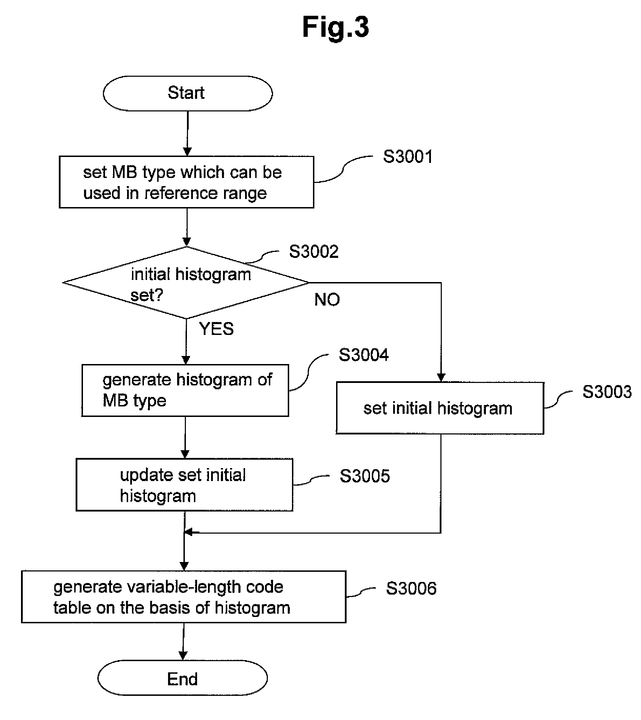

An image coding method (FIG. 3) according to a representative embodiment of the invention is a method of compressing quantized data by variable-length coding, and includes: a first process of storing statistical information of coded image data into a memory; a second process of generating a variable-length code table on the basis of the statistical information stored in the memory; and a third process of performing variable-length coding on the basis of the variable-length code table generated in the second process. The second process is a process of generating a variable-length code table by adding occurrence probability of statistical information calculated in a predetermined range of coded image data and initial occurrence probability selected on the basis of a coding parameter (S3005), and assigning a short code in descending order of statistical information of high occurrence probability obtained by the addition (S3006). In such a manner, the variable-length decode table can be updated according to characteristics of image data to be processed, and the method can contribute to improvement in compression efficiency of the variable-length coding.

[26] Selection of Code in Variable-Length Code Table (Coding Method)

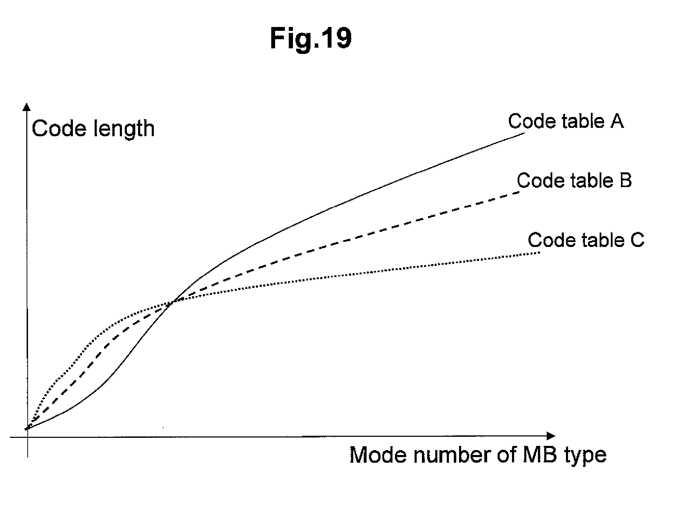

An image coding method (FIG. 19) according to another representative embodiment of the invention is a method of compressing quantized data by variable-length coding, and includes: a first process of storing statistical information of coded image data into a memory; a second process of generating a variable-length code table on the basis of the statistical information stored in the memory; and a third process of performing variable-length coding on the basis of the variable-length code table generated in the second process. The second process is a process of generating a variable-length code table by selecting a code used for a variable-length code table in accordance with the proportion of statistical information of high occurrence probability on entire statistical information calculated within a predetermined range of the coded image data and assigning a short code in descending order of the calculated statistical information of the high occurrence probability. Since a code used for the variable-length code table can be selected in the case of generating the variable-length code table on the basis of the occurrence probability of statistical information, the method can contribute to further improvement in compression efficiency of the variable-length coding in accordance with the property of a code selected.

[27] Use of Initial Variable-Length Code Table When Statistics Length Is Small (Coding Method)

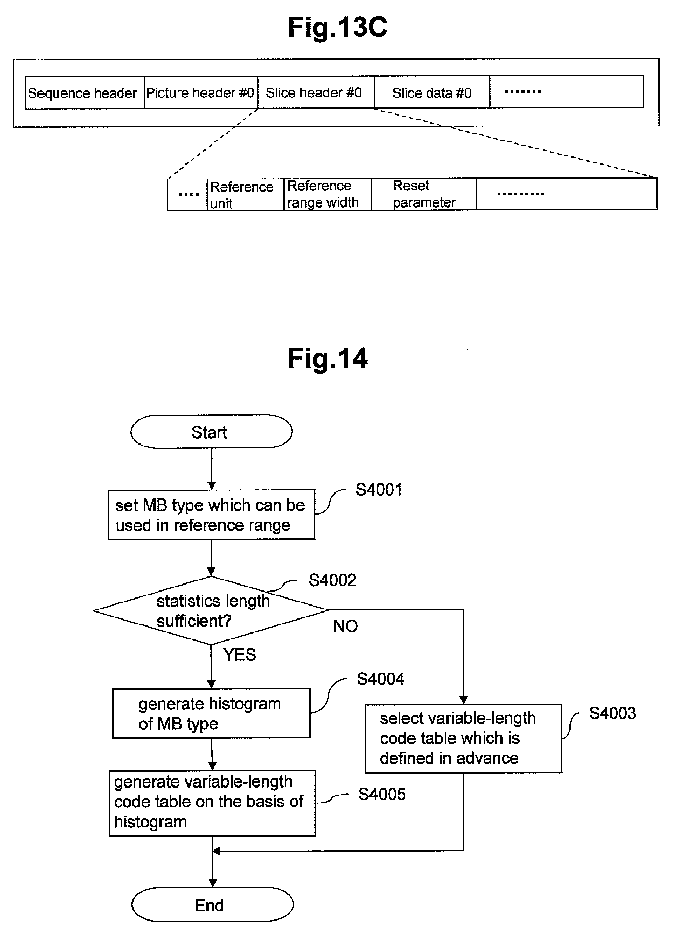

An image coding method (FIG. 14) according to another representative embodiment of the invention is a method of compressing quantized data by variable-length coding, and includes: a first process of storing statistical information of coded image data into a memory; a second process of generating a variable-length code table on the basis of the statistical information stored in the memory; and a third process of performing variable-length coding on the basis of the variable-length code table generated in the second process. The second process is a process of generating a variable-length code table by determining whether or not statistical information which can be referred to at the time of calculating occurrence probability of statistical information satisfies preliminarily-set statistics length or not (S4002), when the statistics length is not satisfied, selecting a predetermined variable-length code table and setting it to be usable (S4003) and, when the statistics length is satisfied, assigning a short code in descending order of the statistical information of the high occurrence probability on the basis of the occurrence probability of the statistical information calculated in a predetermined range (S4004 and S4005). Even when there is no sufficient statistics length, the method can contribute to improvement in compression efficiency of the variable-length coding.

[28] Determination of Reference Range by Degree of Similarity of Histograms (Coding Method)

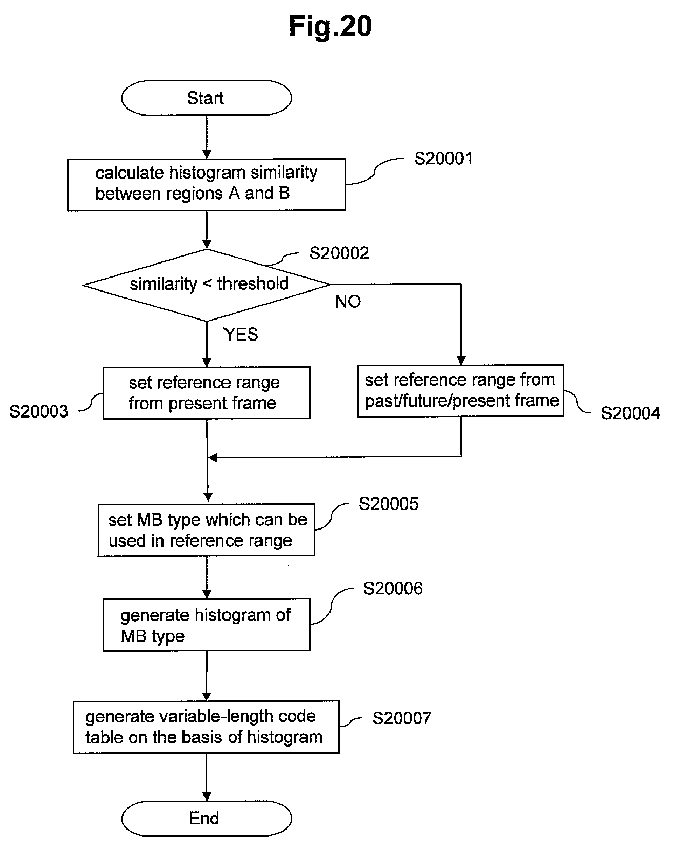

An image coding method (FIG. 20) according to another representative embodiment of the invention is a method of compressing quantized data by variable-length coding, and includes: a first process of storing statistical information of coded image data into a memory; a second process of generating a variable-length code table on the basis of the statistical information stored in the memory; and a third process of performing variable-length coding on the basis of the variable-length code table generated in the second process. The second process is a process of determining the degree of similarity of a histogram on occurrence probability of statistical information calculated in a plurality of positions in coded image data, determining a predetermined range for calculating the occurrence probability in accordance with the degree of similarity, and generating a variable-length code table on the basis of the occurrence probability of the statistical information calculated in the determined predetermined range. Since the reference range can be determined according to the degree of similarity, in this point as well, the method can contribute to improvement in compression rate of the variable-length coding.

[29] Reference To Present Frame At Low Degree of Similarity, and Reference To Past/Future Frame At High Degree of Similarity (Coding Method)

In the image coding method of [28], in the second process, when the degree of similarity of the histograms is smaller than a threshold, a predetermined range for calculating occurrence probability is determined in a present frame. When the degree of similarity of the histograms is larger than a threshold, a predetermined range for calculating the occurrence probability is determined in a past or future frame.

[30] Addition and Updating of Occurrence Probability (Coding Method)

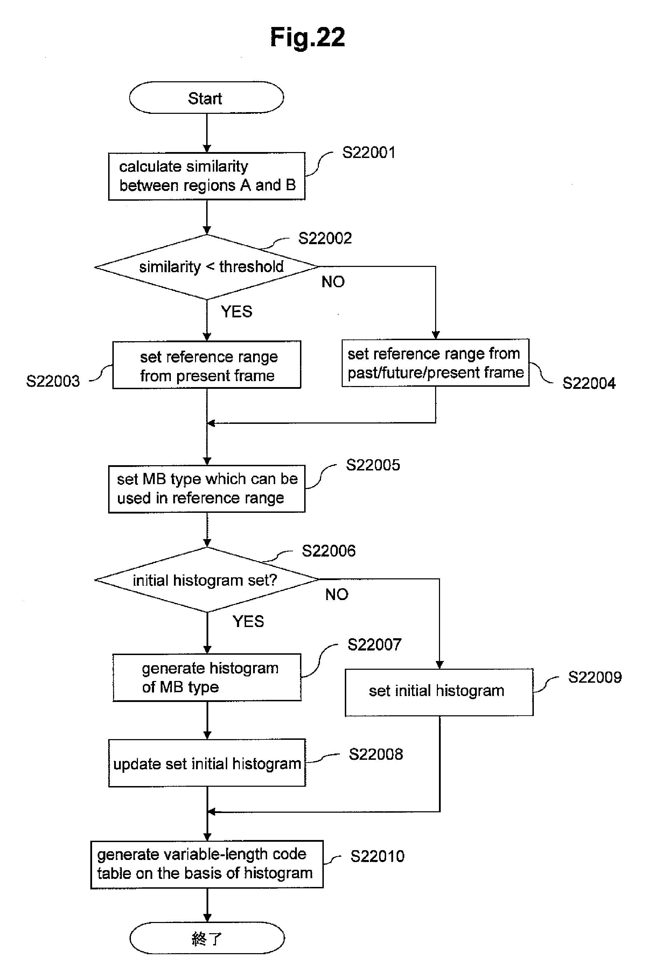

In the coding method of [28], the second process is a process of generating a variable-length code table by adding occurrence probability of statistical information calculated in the determined predetermined range of coded image data and initial occurrence probability selected on the basis of a decode parameter, and assigning a short code in descending order of statistical information of high occurrence probability obtained by the addition (FIG. 22).

[31] Determination of Reference Range By Motion Vector (Coding Method)

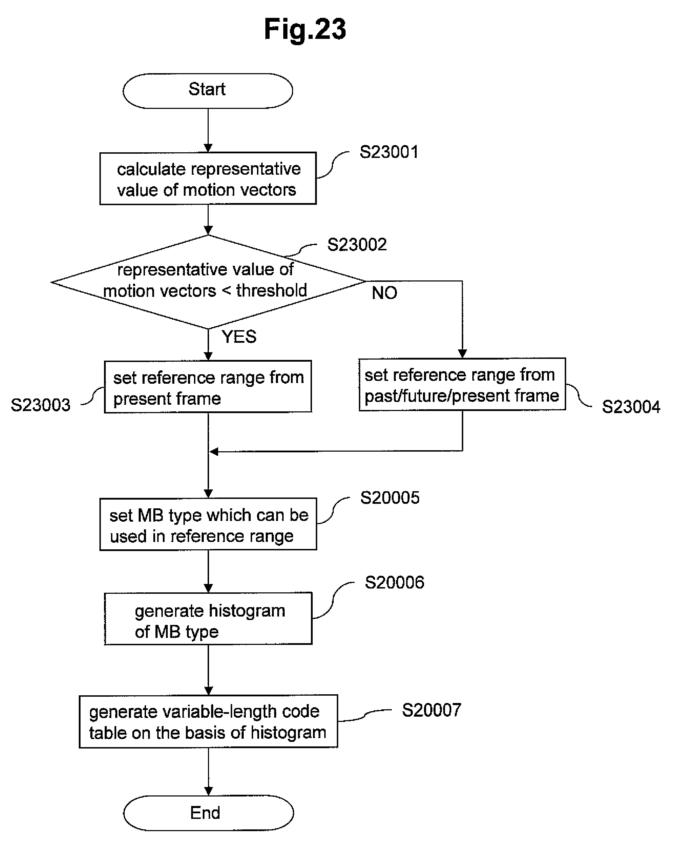

An image coding method (FIG. 23) according to another representative embodiment of the invention is a method of coding quantized data, and includes: a first process of storing statistical information of coded image data into a memory; a second process of generating a variable-length code table on the basis of the statistical information stored in the memory; and a third process of performing variable-length coding on the basis of the variable-length code table generated in the second process. The second process is a process of generating a variable-length code table by generating a motion vector in a predetermined range of a block to be coded in a present frame of the coded image data, determining a predetermined range for calculating occurrence probability on the basis of the generated motion vector, and assigning a short code in descending order of statistical information of the occurrence probability of the statistical information in the predetermined range. Since the reference range can be determined according to the motion vector, in this point as well, the method can contribute to improvement in compression efficiency of the variable-length coding.

[32] In the image coding method of [31], in the second process, when the generated motion vector is larger than a threshold, a variable-length code table is generated by assigning a short code in descending order of statistical information of high occurrence probability of the statistical information in the predetermined range in a present frame and, when the generated motion vector is smaller than a threshold, a variable-length code table is generated by assigning a short code in descending order of statistical information of high occurrence probability in a predetermined range in a past or future frame.

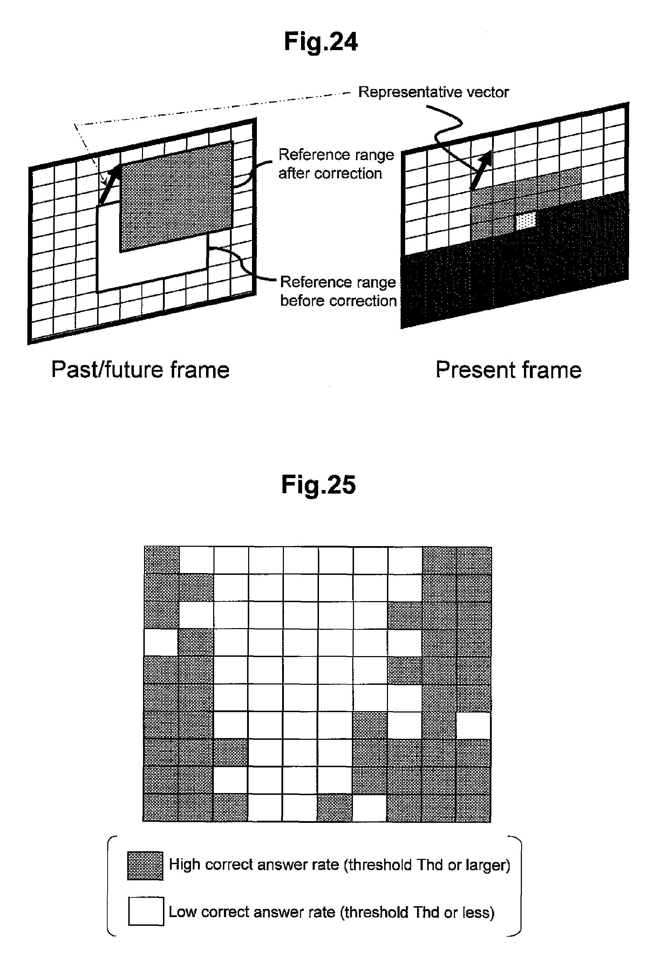

[33] In the image coding method of [31], in the second process, when the generated motion vector is smaller than a threshold, by correcting a predetermined range in a past or future frame by the generated motion vector and assigning a short code in descending order of statistical information of high occurrence probability of the statistical information in the corrected predetermined range, a variable-length code table is generated (FIG. 24).

[34] Determination of Reference Range by Actual Performance of Variable-Length Coding (Coding Method)

An image coding method (FIG. 25) according to another representative embodiment of the invention is a method of compressing quantized data by variable-length coding, and includes: a first process of storing statistical information of coded image data into a memory; a second process of generating a variable-length code table on the basis of the statistical information stored in the memory; and a third process of performing variable-length coding on the basis of the variable-length code table generated in the second process. The second process is a process of generating a variable-length code table by assigning a short code in descending order of statistical information of the occurrence probability of the statistical information in the predetermined range in which the number of bits of a code to be variable-length coded in a past frame is predetermined number of bits or less. Since the reference range is determined in response to a range of high compression rate according to the actual record of variable-length coding, the method can contribute to improvement in compression efficiency of the variable-length coding.

[35] Addition and Updating of Occurrence Probability (Coding Apparatus)

An image coding apparatus according to a representative embodiment of the invention is an apparatus for compressing quantized data by variable-length coding and includes: a memory (212) for storing statistical information (MBT, CBPL) of coded image data; a variable-length code table generating unit (213) for generating a variable-length code table on the basis of the statistical information stored in the memory; and a variable-length coding unit (205) for performing variable-length coding on the basis of the variable-length code table generated by the variable-length code table generating unit. The variable-length code table generating unit generates a variable-length code table by adding occurrence probability of statistical information calculated within a predetermined range of the coded image data and initial occurrence probability selected on the basis of a coding parameter (S3005), and assigning a short code in descending order of statistical information obtained by the addition (S3006). By the apparatus, the compression efficiency of the variable-length coding can be improved according to the characteristics of image data to be processed.

[36] Selection of Code in Variable-Length Code Table (Coding Apparatus)

An image coding apparatus according to a representative embodiment of the invention is an apparatus of compressing quantized data by variable-length coding, and includes: a memory for storing statistical information of coded image data; a variable-length code table generating unit for generating a variable-length code table on the basis of the statistical information stored in the memory; and a variable-length coding unit for performing variable-length coding on the basis of the variable-length code table generated by the variable-length code table generating unit. The variable-length code table generating unit generates a variable-length code table by selecting a code used for a variable-length code table in accordance with the proportion of statistical information of high occurrence probability on entire statistical information calculated within a predetermined range of the coded image data and assigning a short code in descending order of the calculated statistical information of the high occurrence probability. In the case of generating a variable-length code table on the basis of the occurrence probability of statistical information, a code used for the variable-length code table can be selected. Consequently, the apparatus can contribute to further improvement in compression efficiency of the variable-length coding according to the property of a code to be selected.

[37] Use of Initial Variable-Length Code Table When Statistics Length Is Small (Coding Apparatus)

An image coding apparatus according to a representative embodiment of the invention is an apparatus for compressing quantized data by variable-length coding and includes: a memory for storing statistical information of coded image data; a variable-length code table generating unit for generating a variable-length code table on the basis of the statistical information stored in the memory; and a variable-length coding unit for performing variable-length coding on the basis of the variable-length code table generated by the variable-length code table generating unit. The variable-length code table generating unit generates a variable-length code table by determining whether or not statistical information which can be referred to at the time of calculating occurrence probability of statistical information satisfies preliminarily-set statistics length (S4002), when the statistics length is not satisfied, selecting a predetermined variable-length code table and setting it to be usable (S4003) and, when the statistics length is satisfied, assigning a short code in descending order of the statistical information of the high occurrence probability on the basis of the occurrence probability of the statistical information calculated in a predetermined range (S4004 and 54005). Even when there is no sufficient statistics length, the apparatus can contribute to improvement in compression efficiency of variable-length coding.

[38] Determination of Reference Range by Degree of Similarity of Histograms (Coding Apparatus)

An image coding apparatus according to a representative embodiment of the invention is an apparatus for compressing quantized data by variable-length coding and includes: a memory for storing statistical information of coded image data; a variable-length code table generating unit for generating a variable-length code table on the basis of the statistical information stored in the memory; and a variable-length coding unit for performing variable-length coding on the basis of the variable-length code table generated by the variable-length code table generating unit. The variable-length code table generating unit generates a variable-length code table by determining the degree of similarity of a histogram on occurrence probability of statistical information calculated in a plurality of positions in coded image data, determining a predetermined range for calculating the occurrence probability in accordance with the degree of similarity, and generating a variable-length code table on the basis of the occurrence probability of the statistical information calculated in the determined predetermined range.

[39] Reference To Present Frame At Low Degree of Similarity, and Reference To Past/Future Frame At High Degree of Similarity (Coding Apparatus)

In the coding apparatus of [38], when the degree of similarity of the histogram is smaller than a threshold, the variable-length code table generating unit determines a predetermined range for calculating occurrence probability in a present frame. When the degree of similarity of the histogram is larger than a threshold, the variable-length code table generating unit determines a predetermined range for calculating the occurrence probability in a past or future frame.

[40] Addition and Updating of Occurrence Probability (Coding Apparatus)

In the coding apparatus of [38], the variable-length code table generating unit performs a process of generating a variable-length code table by adding occurrence probability of statistical information calculated in the determined predetermined range of coded image data and initial occurrence probability selected on the basis of a decode parameter, and assigning a short code in descending order of statistical information of high occurrence probability obtained by the addition.

[41] Determination of Reference Range by Motion Vector (Coding Apparatus)

An image coding apparatus according to a representative embodiment of the invention is an apparatus for compressing quantized data by variable-length coding and includes: a memory for storing statistical information of coded image data; a variable-length code table generating unit for generating a variable-length code table on the basis of the statistical information stored in the memory; and a variable-length coding unit for performing variable-length coding on the basis of the variable-length code table generated by the second process. The variable-length code table generating unit generates a variable-length code table by generating a motion vector in a predetermined range of a block to be coded in a present frame of the coded image data, determining a predetermined range for calculating occurrence probability on the basis of the generated motion vector, and assigning a short code in descending order of statistical information of the occurrence probability of the statistical information in the predetermined range.

[42] In the coding apparatus of [41], when the generated motion vector is larger than a threshold, the variable-length code table generating unit generates a variable-length code table by assigning a short code in descending order of statistical information of high occurrence probability of the statistical information in the predetermined range in a present frame. When the generated motion vector is smaller than a threshold, the variable-length code table generating unit generates a variable-length code table by assigning a short code in descending order of statistical information of high occurrence probability in a predetermined range in a past or future frame.

[43] In the coding apparatus of [41], when the generated motion vector is smaller than a threshold, the variable-length code table generating unit generates a variable-length code table by correcting a predetermined range in a past or future frame by the generated motion vector and assigning a short code in descending order of statistical information of high occurrence probability of the statistical information in the corrected predetermined range.

[44] Determination of Reference Range by Actual Performance of Variable-Length Coding (Coding Apparatus)

An image coding apparatus according to another representative embodiment of the invention is an apparatus for compressing quantized data by variable-length coding and includes: a memory for storing statistical information of coded image data; a variable-length code table generating unit for generating a variable-length code table on the basis of the statistical information stored in the memory; and a variable-length coding unit for performing variable-length coding on the basis of the variable-length code table generated by the variable-length code table generating unit. The variable-length code table generating unit generates a variable-length code table by assigning a short code in descending order of statistical information of the occurrence probability of the statistical information in the predetermined range in which the number of bits of a code to be variable-length coded in a past frame is predetermined number of bits or less.

2. Further detailed description of the embodiments

The embodiments will be described more specifically. «First Embodiment»

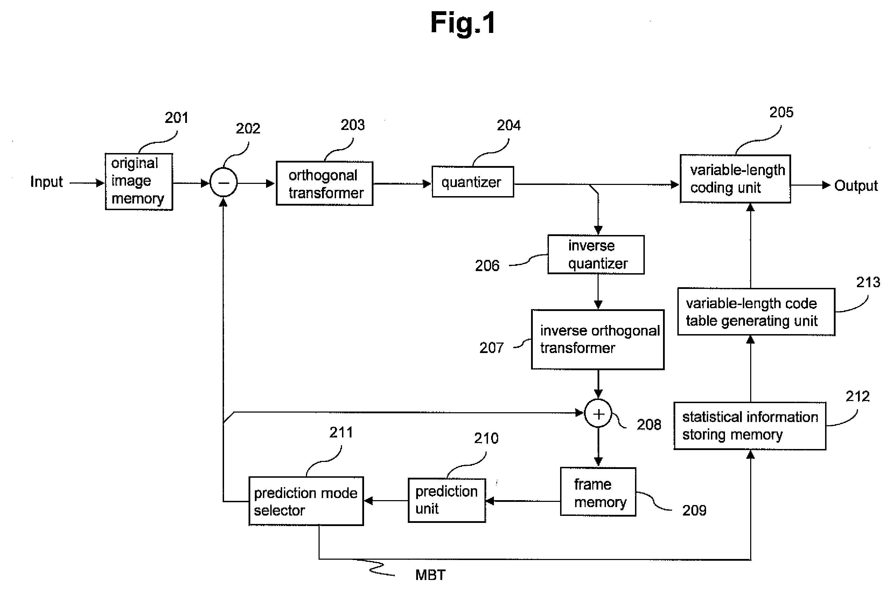

FIG. 1 is a block diagram showing an example of an image coding apparatus according to the present invention. The image coding apparatus shown in the diagram has an original image memory 201, a subtractor 202, an orthogonal transformer 203, a quantizer 204, a variable-length coding unit 205, an inverse quantizer 206, an inverse orthogonal transformer 207, an adder 208, a frame memory 209, a prediction unit 210, a prediction mode selector 211, a statistical information storing memory 212, and a variable-length code table generating unit 213.

The original image memory 201 temporarily buffers data of an original image frame. The subtractor 202 obtains the difference between an original image and a predicted image and generates a differential image. The orthogonal transformer 203 transforms the differential image generated by the subtractor 202 to an orthogonal transform coefficient by using an orthogonal transform method such as DCT. The quantizer 204 quantizes the orthogonal transform coefficient and outputs a quantized coefficient. The variable-length coding unit 205 codes the quantized coefficient output from the quantizer 204, a prediction mode output from the prediction mode selector 211, and the like by using a Huffman code, an arithmetic code, and the like, and outputs the result as image compression information. The inverse quantizer 206 inversely quantizes the quantized coefficient which is output from the quantizer 204. The inverse orthogonal transformer 207 inversely orthogonal-transforms the inversely quantized coefficient which is output from the inverse quantizer 206. The adder 208 adds the differential image output from the inverse orthogonal transform unit 207 and a predicted image which is output from the prediction mode selector 211, and outputs a local decoded image. The frame memory 209 stores the local decoded image generated by the adder 208. The prediction unit 210 performs prediction by using the local decoded image stored in the frame memory 209. The prediction mode selector 211 selects one prediction mode of the highest prediction efficiency and outputs the prediction mode and the predicted image. The statistical information storing memory 212 refers to the prediction mode which is output from the prediction mode selector 211 and stores an MB type (MBT) of a block to be coded by addresses of blocks. The variable-length code table generating unit 213 generates a histogram of the MB type by using an MB type of a coded macro block (MB) stored in the statistical information storing memory 212 in a proper range, adds the generated one to the initial histogram and, after that, assigns a short code in descending order of the occurrence probability, thereby generating a suitable variable-length code table. The range which is referred to at the time of generating the histogram and the MB type referred to in the range are set variably, and the generated histogram is added using the initial histogram as a start point and updated. The variable-length coding unit 205 codes a macroblock type as a prediction mode which is output from the prediction mode selector by using the generated variable-length code table.

By using a code other than an exponential Golomb used in the H.264 standard at the time of generating the variable-length code table, the compression rate can be increased. For example, as shown in FIG. 19, a code table A, B, or C is used. In the code table A, a code word which is as short as possible is assigned to a small mode number and a code word which becomes sharply longer is assigned to a large mode number. In the code table C, a code word which is rather long is assigned to a small mode number and, yet, a code word which is not so long is assigned to a large mode number. The code table B has an intermediate characteristic between the code tables A and C. By defining some code tables and selecting a proper code table in accordance with the distribution of the occurrence probabilities of the MB type, the compression rate can be further increased. An example of the method of selecting a proper code table is a method of calculating the proportion of the highest mode and the second highest mode in the entire appearance modes, using the code table A when the proportion is equal to or larger than a threshold A, using the code table C when the proportion is equal to or less than a threshold C, and using the code table B when the proportion is equal to or less than the threshold A and equal to or larger than the threshold C. Another example is a method of generating code words for modes by using the code tables A to C and selecting a code table in which an expectation value of the average code length is the smallest in consideration of the occurrence probability. A proper code table may be also selected by a process other than the above-described method, or a code table to be used may be specified in advance by prospective knowledge. In short, in the case of assigning a short code in descending order of the occurrence probability at the time of generating a code table on the basis of a histogram, by selecting a code having a certain characteristic or tendency, a variable-length code table is generated. For example, an exponential Golomb code can be employed for the code table B, and codes having characteristics as shown in FIG. 19 may be employed for the code tables A and C.

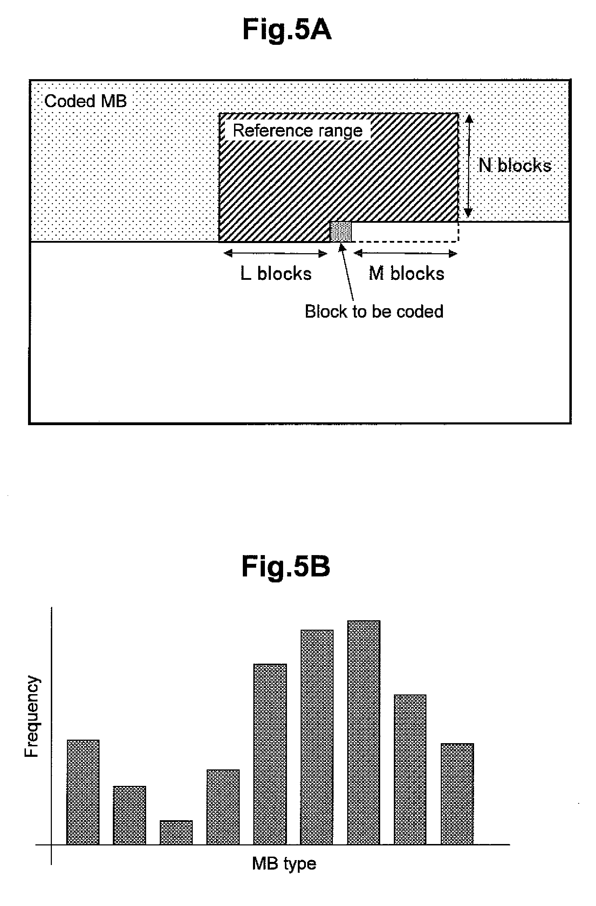

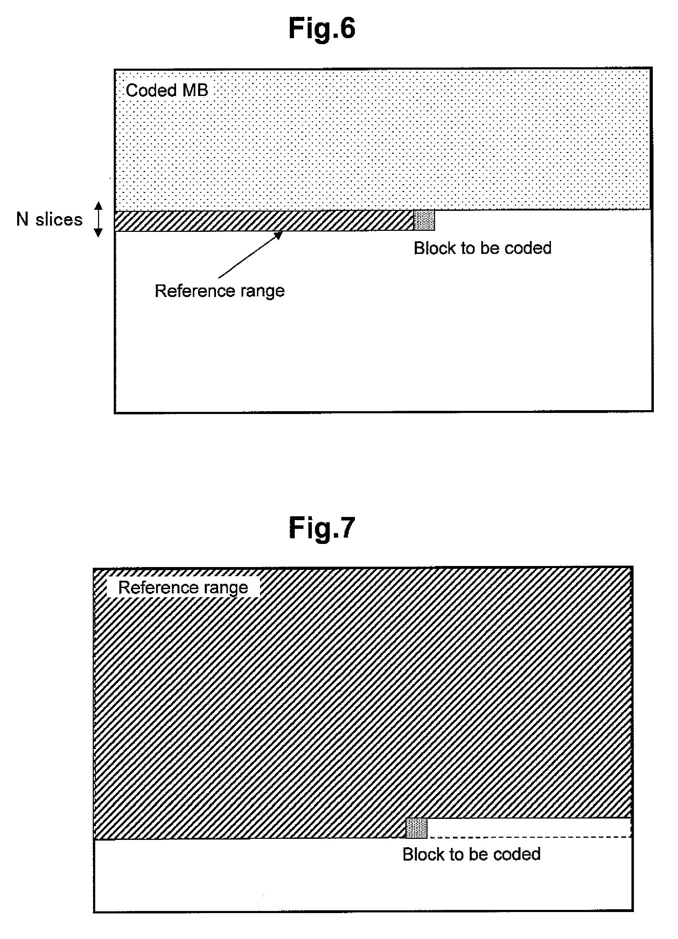

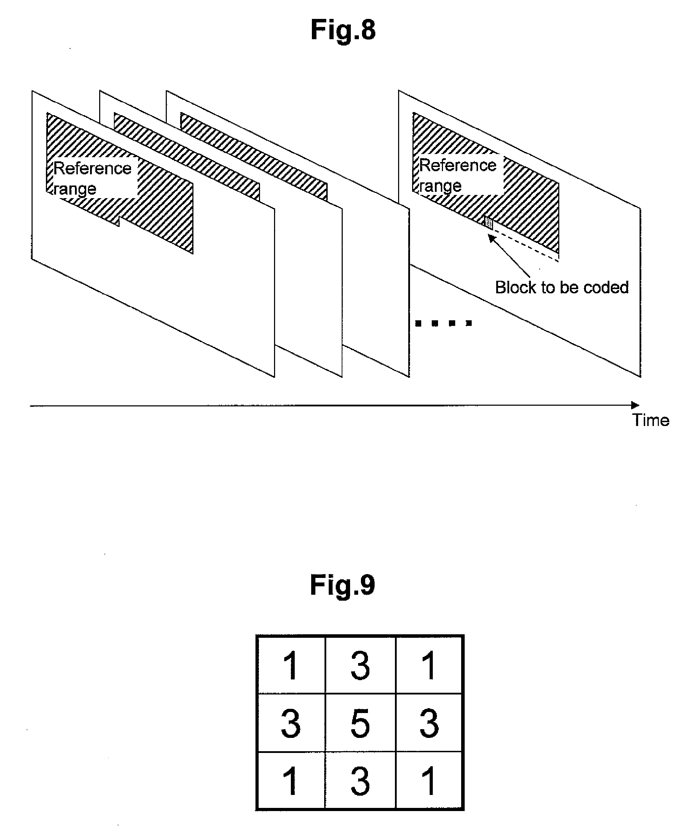

FIG. 3 is a flowchart of processes performed by the variable-length code table generating unit 213. First, an MB type which can be used in a reference range for generating a histogram is selected (S3001). For example, only an MB type which can be used in the reference range is regarded as a valid mode on the basis of a slice type included in the reference range, and a base table for generating a histogram is generated. For example, as shown in FIG. 5A, the reference range is determined in advance so that the periphery of a present block to be coded is referred to. In addition, the setting may be made so that a slice unit (FIG. 6), a picture unit (FIG. 7), and a sequence unit (FIG. 8) is referred to. The setting may be also made so that a combination of the units, for example, both of the periphery of a present block to be coded and the periphery of a block to be coded in an arbitrary frame (t-N or t+N) are referred to. By setting a reference position in accordance with the picture type and the slice type of a present object to be coded at the time of determining the reference range, the compression rate can be further increased. For example, when the present object to be coded is a P picture, by referring to the immediately preceding P picture (or a P picture N frames before), a more suitable histogram can be generated. Similarly, when the picture type of a present object to be coded is the B picture, by referring to the immediately preceding B picture (or a B picture N frames before), a more suitable histogram can be generated. This is similarly applied to the I picture.

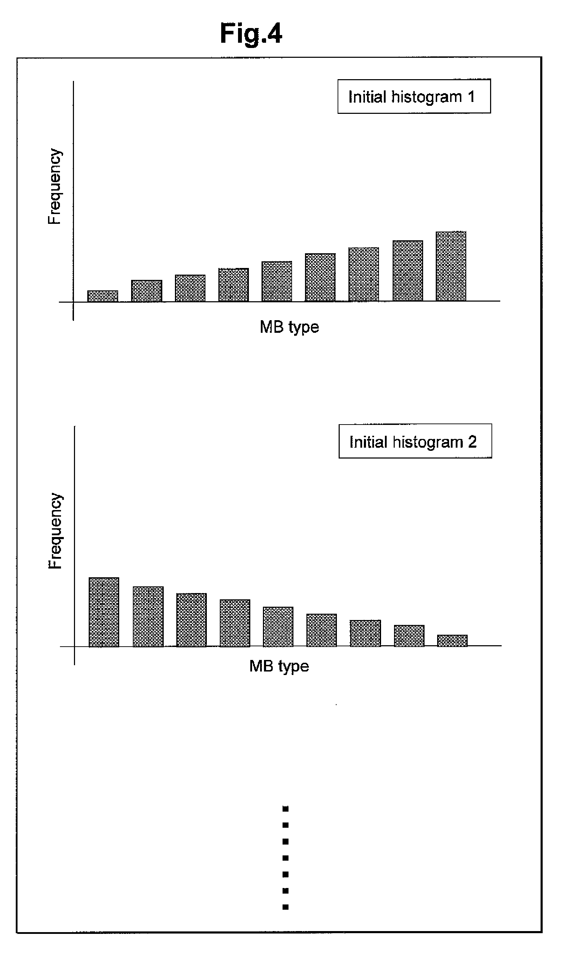

FIG. 5B shows an example of the frequency distribution of the MB type in the reference range in FIG. 5A. Although not shown, before step S3001, a designated reference range is grasped. Next, whether an initial histogram is set or not is determined (S3002). As shown in FIG. 4, the initial histogram gives an offset to the occurrence probability of each MB type. When the initial histogram is not set, a proper initial histogram is selected (S3003). As a selecting method, it is sufficient to preliminarily define a table to unconditionally determine the initial histogram in relation to the screen size, an initial quantization value, and the like and select an initial histogram on the basis of a coding parameter by using the table. By assigning a short code in descending order of the occurrence probability only to MB types which are regarded as valid in the initial histogram selected in step S3003, a variable-length code table is generated (S3006). By using the initial histogram, weights can be increased to MB types which tend to appear generally, so that coding can be performed effectively in consideration of both prospective knowledge and statistics of the present coding situation.

Once an initial histogram is set, the initial histogram is updated each time the coding is performed. First, a histogram of the MB type in the reference range is generated (S3004). Next, the frequency obtained in step S3004 is added to the initial histogram to update the initial histogram (S3005) . Finally, a short code is assigned in the descending order of the occurrence probability to a valid MB type in the histogram selected and updated by the above procedure, thereby generating a suitable variable-length code table (S3006). Each time the coding is performed, a histogram in the reference range is generated and added to the initial histogram which is set in S3003 to generate a variable-length code table by a similar procedure. In the case where the occurrence probabilities are the same, it is sufficient to assign a code on the basis of the frequency of the initial histogram or a table describing the assigning order.

With respect to the histogram generating method, a weight according to the degree of importance can be set to an MB type in the reference range. For example, a histogram may be generated by using a function of weight which decreases with distance from a block to be coded as shown in mathematical expression 1.

$$w(x, y, t) = \frac{a}{(x - x_0)^2 + (y - y_0)^2 + (t - t_0)^2} \qquad \text{... Expression 1}$$

Here, $x_0$, $y_0$, $t_0$ denote three-dimensional positions of a block to be coded, "x, y, t" denote three-dimensional positions of a block in the reference range, and "a" denotes a parameter for adjusting weight. The weight may be set by applying a filter whose cost decreases with distance from a block to be coded as a center as shown in FIG. 9 to a space-time direction. In FIG. 9, when the weight on the block to be coded is set to 5, a weight smaller than 5, which is 1 or 3, is given to the peripheral blocks. By performing weighting according to the degree of importance, that is, weighting according to the degree of influence on an MB to be coded as described above, an MB type which tends to appear in the block to be coded can be predicted more properly, so that the compression rate can be further increased.

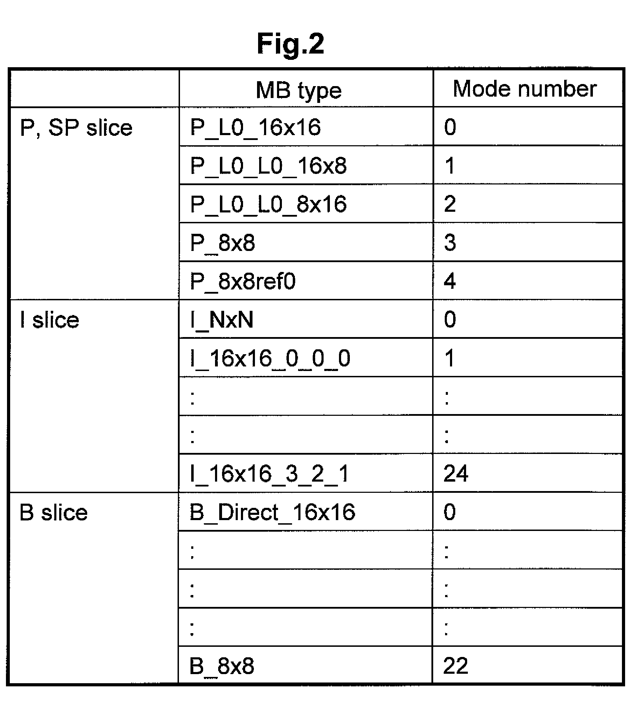

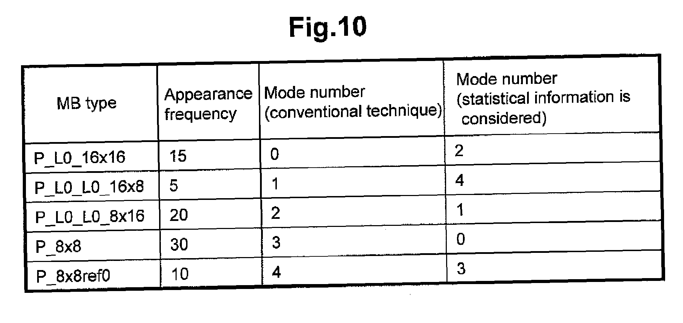

FIG. 10 shows an example of the variable-length code table generated by the variable-length coding technique according to the embodiment. FIG. 2 shows a variable-length code table as a comparative example in which the macro block type and the mode number are fixed and the mode numbers are assigned without consideration of actual appearance frequency, and illustrates assignment of the MB types on assumption of the H.264 standard. In the case of FIG. 10, the smaller mode numbers as shorter codes are assigned in descending order of the appearance frequency, so that the compression rate can be increased. In FIG. 10, the column described as "conventional case" refers to the assignment in FIG. 2, and the column described as "statistic information is considered" refers to the assignment according to the present invention.

Although the MB types shown in FIG. 10 are described on assumption that the MB types are of the H.264 standard, other MB types which are not defined in the standard may be included. A skip mode which is coded independently in the H.264 standard may be included in the variable-length code table. In the case of coding a skip mode, the skip mode may be individually coded in a manner similar to the H.264 standard. In this case, coding may be performed by using a code other than the exponential Golomb on mb_skip_run as a syntax element specifying the existence of continuous skip macro blocks.

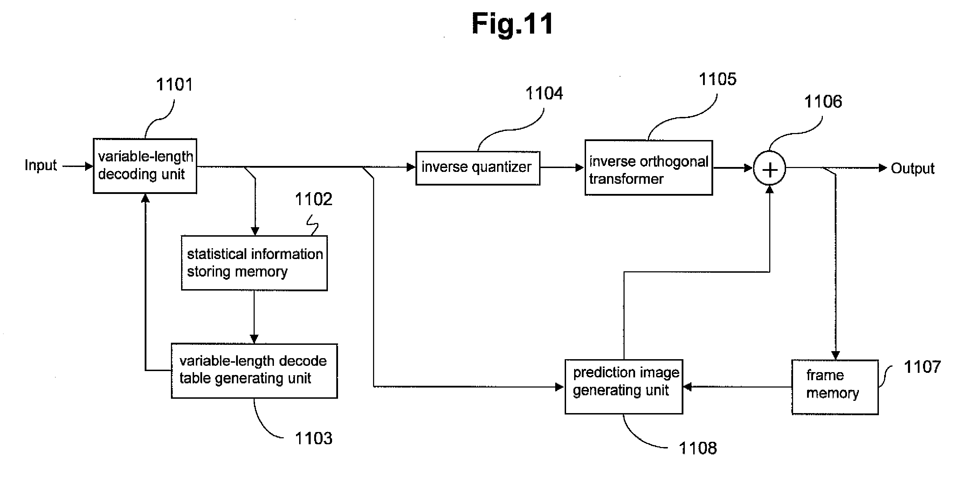

FIG. 11 illustrates the configuration of an image decoding apparatus according to the invention. The image decoding apparatus has a variable-length decoding unit 1101, a statistical information storing memory 1102, a variable-length decode table generating unit 1103, an inverse quantizer 1104, an inverse orthogonal transformer 1105, an adder 1106, a frame memory 1107, and a prediction image generating unit 1108.

The variable-length decoding unit 1101 decodes image compression information which is transmitted. The statistical information storing memory 1102 stores MB types (MBT) by addresses of blocks. The variable-length decode table generating unit 1103 generates a suitable variable-length decode table by obtaining the occurrence probability of the decoded MB type stored in the statistical information storing memory 1102 within a reference range, adding it to an initial histogram, and assigning short codes in descending order of the occurrence probability to valid MB types. Since it is sufficient to employ a procedure similar to the process flow in the image coding apparatus described with reference to FIG. 3 and the like as the generating procedure, the detailed description of the procedure will not be given here. The inverse quantizer 1104 inversely quantizes a quantized coefficient. The inverse orthogonal transformer 1105 inversely transforms an inverse quantized coefficient which is output from the inverse quantizer 1104. The adder 1106 adds a differential image which is output from the inverse orthogonal transformer 1105 and a prediction image which is output from the prediction image generating unit 1108, and outputs a decoded image. The frame memory 1107 stores the decoded image. The prediction image generating unit 1108 generates a prediction image on the basis of the decoded image stored in the frame memory 1107 and the MB type output from the variable-length decoding unit 1103.

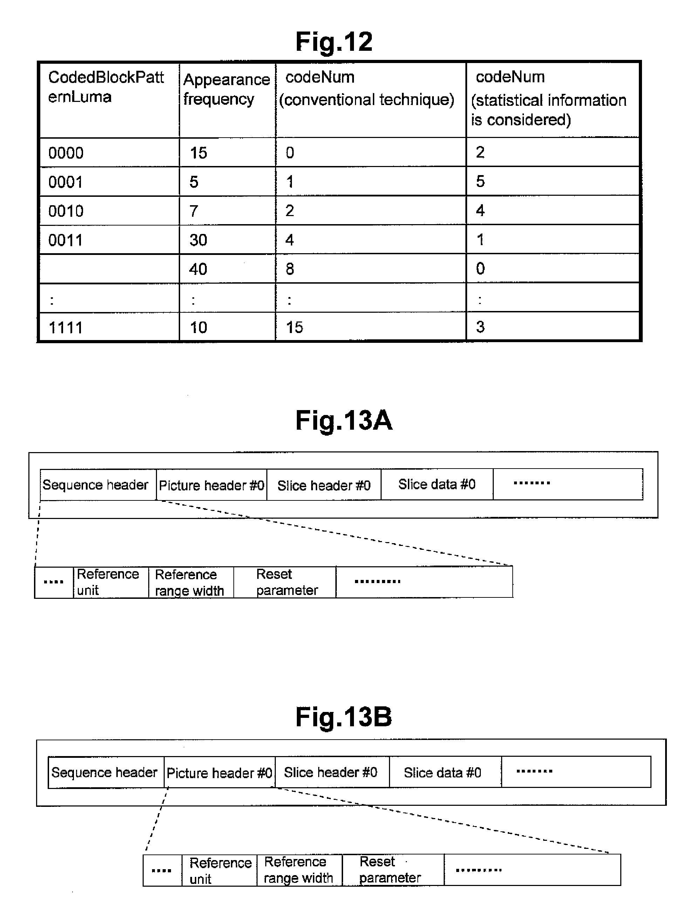

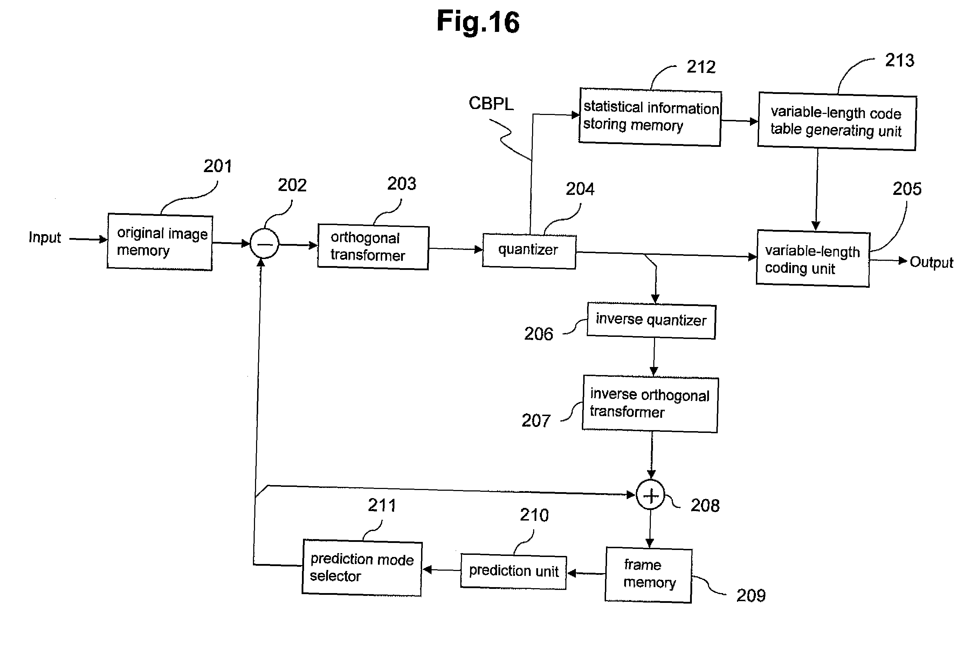

Although the MB type is taken as an example in the above description, the compression rate can be increased by applying a similar method also at the time of variable-length coding a coded block pattern (CBP) parameter. For example, a case of variable-length coding CodedBlockPatternLuma will be examined. It is now assumed that CodedBlockPatternLuma expresses a distribution of DCT coefficients of brightness components in one macro block by four bits. FIG. 16 shows an example of the configuration of an image coding apparatus for generating a variable-length code table on the basis of the occurrence probability of CodedBlockPatternLuma. The configuration is similar to that of FIG. 1 but is different with respect to the point that the quantizer 204 outputs information of CodedBlockPatternLuma (CBPL), and a variable-length code table of CodedBlockPatternLuma is generated by the variable-length code table coding unit 213. FIG. 12 shows an example of generating a variable-length code table of CodedBlockPatternLuma by the above-described method. By applying the method to codes in 16 patterns, a suitable code can be assigned according to the occurrence probability. In FIG. 12, the column described as "conventional technique" shows existing assignment which does not use the occurrence probability, and the column described as "statistical information is considered" indicates the assignment according to the present invention.

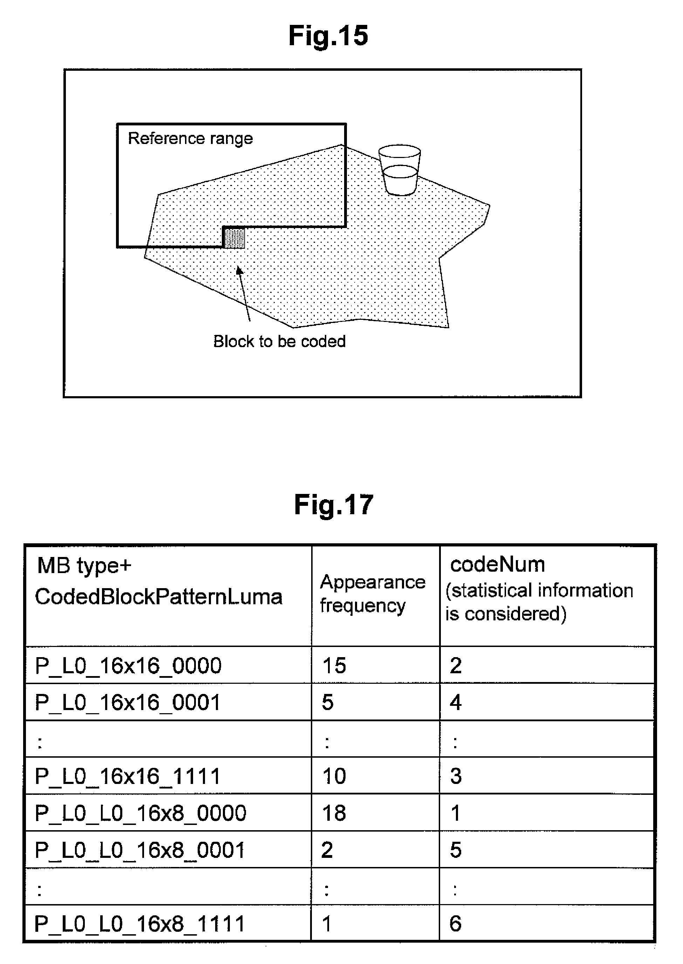

The above method is applied not only to CodedBlockPatternLuma but also similarly to CodedBlockPatternChroma. As shown in FIG. 17, as a method of defining the MB type and CodedBlockPatternLuma by the same variable-length code table, a variable-length code table including both the MB type and CodedBlockPatternLuma may be generated. Although the coefficient distribution of the brightness component of one macroblock is expressed by four bits in the above-described example, it may be expressed by combination of a brightness component and a color-difference component. The invention is not limited to the components of one macroblock. Components in a few macroblocks may be expressed in a lump.

In the foregoing first embodiment, adaptive variable-length coding based on the occurrence probability of the MB type and the CBP parameter can be performed, and the compression rate can be increased. By performing the similar variable-length code table/decode table generating processes in the coding apparatus and the decoding apparatus, the necessity of transmitting extra additional information is avoided so that the compression rate can be increased. Since the initial histogram is selected on the basis of the image size and the quantization parameter, also at the coding initial stage where the statistical length is insufficient, high compression rate can be obtained. At the time of generating a variable-length code table on the basis of a histogram, by selecting a proper code word on the basis of the occurrence probability distribution tendency, the compression rate can be increased. By setting a weight according to the degree of importance at the time of generating a histogram, a variable-length code table which is more adapted to the property of an image can be generated. Obviously, the technical matters described in the variable-length coding can be similarly applied to the variable-length decoding process.

«Second Embodiment»

Some methods of designating a parameter used for variable-length coding/decoding, for example, a parameter such as a reference range for the histogram generation will be described by paying attention to the description of coded stream information which is generated in the variable-length coding unit 205 in FIG. 1 and is decoded in the variable-length decoding unit 1101 in FIG. 11. FIGS. 13A and 13B schematically show the coded stream. As shown in the diagrams, the coded stream includes header information such as a sequence header, a picture header, and a slice header, and image information such as slice data. In this case, information related to the reference range in the first embodiment is included in the header information.

For example, in the sequence header, a reference unit (vlc_reference_unit) specifying a range of calculating occurrence probability of an event is defined by the variable-length code table generating unit 213. Vlc_reference_unit indicates a syntax element for determining that the reference range is a peripheral unit, a slice unit, a picture unit, a sequence unit, or other units.

In addition, a reference range width (vlc_reference_range) for specifying a detailed reference range is defined. In the example of FIG. 5A in which the peripheral unit is the reference range, vlc_reference_block_range showing the block width from a block to be coded is defined. For example, when vlc_reference_block_range=5, using the block to be coded as a center, a rectangle shape of 11 blocks in the horizontal direction by six blocks in the vertical direction is set to the reference range. Since all of blocks below the block to be coded and five blocks on the right side of the block to be coded are not coded yet, they are not included in the reference range. vlc_reference_block_range may be set to be variable in the vertical and horizontal directions, and the reference range width from the block to be coded may be set in a free rectangle by, for example, vlc_reference_block_range_left, vlc_reference_block_range_top, and vlc_reference_block_range_right. The reference range width vlc_reference_slice_range in the slice unit and the reference range in the picture unit in the examples of FIGS. 6 and 7, the reference range width vlc_reference_sequence_range in the sequence unit in the example of FIG. 8, and the like are defined. It is also possible to use a parameter designating a reference position, not the reference range width. In the case of using a picture as a reference unit, the picture number to be referred to can be designated. For example, it can be variably set to refer to an immediately preceding picture (t-1), a designated picture (t-N), or the like. It is also possible to provide vlc_reference_arbitrary_shape_range specifying a reference range of an arbitrary shape. vlc_reference_arbitrary_shape_range may be arrangement of block numbers or pixel numbers, or an arbitrary shape may be specified by a coefficient using a parametric curve such as Bezier curve. A reset parameter (vlc_reset_param) indicative of the timing of updating the initial histogram is defined. For example, a parameter of updating the initial histogram every 15 frames is set.

The parameters may be included in a sequence header as shown in the example of setting the reference range in FIG. 13A, and the same settings may be succeeded by the entire sequence to be coded, or the parameters may be included in each of the picture header and the slice header as shown in FIGS. 13B and 13C and the settings may be varied in each of the layers. By making the valid range of the parameters variable, the reference range setting according to the characteristics of a motion image can be performed, so that the compression rate can be increased.

The process of the variable-length code table generating unit 213 described with reference to FIG. 1 in the first embodiment is not limited to selection and updating of the initial histogram. A procedure of using an initial variable-length code table during a period in which the statistics length is insufficient as shown in FIG. 14 may be employed.

In FIG. 14, first, an MB type which can be used in the reference range is set (S4001). Next, whether the statistics length which is set in the syntax element can be sufficiently satisfied or not is determined (S4002). For example, whether statistic information which can be referred to when the picture unit is designated as the reference range is sufficient in the reference range or not is determined. If the statistics length is not sufficient, the variable-length code table which is defined in advance is selected (S4003). As the criterion of selection, it is sufficient to use the image size and the quantization parameter in a manner similar to the first embodiment. When the statistics length is sufficient, a histogram of the MB type in the reference range is generated (S4004). Finally, by assigning short codes in descending order of the occurrence probability to the obtained histogram, the variable-length code table is generated (S4005). Since the initial histogram is not used, the possibility of occurrence of MB types having the same frequency is high. In the case where the frequency is the same, it is sufficient to select a variable-length code table by using the criterion in step S4003 and assign short codes in descending order of mode numbers defined in the table.

As the processes of the variable-length code table generating unit 213, the processes of FIG. 14 or the processes of FIG. 3 described in the first embodiment may be used. Alternatively, without using any of the processes, after sufficient statistics length is assured, the variable-length coding may be performed.

The processes in steps S4004 and S4005 in FIG. 14 may be replaced to steps S3002, S3003, S3004, S3005, and S3006 in FIG. 3.

In the foregoing second embodiment, the user can perform variable-length coding adaptively in a proper reference range in accordance with an assumed application. That is, resistance to an error can be freely set according to reliability of a communication path. Since a variable-length code table is not generated using both the initial histogram and the statistic information, the variable-length code table placing heavier weight on the characteristics of an image to be coded can be generated.

The content described in the second embodiment can be similarly applied also to the processes of the variable-length decode table generating unit 1103.

«Third Embodiment»

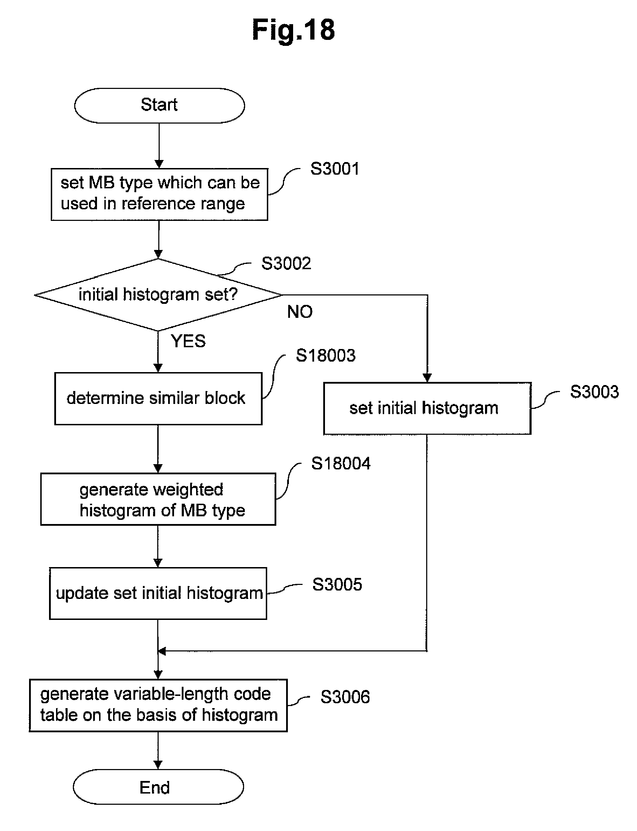

The MB types described in the first embodiment in similar blocks in an image are often the same, also in the CBP parameter. Therefore, as shown in FIG. 15, by extracting a region similar to a block to be coded in a reference region and generating a histogram so that weight is increased in a region having high degree of similarity and weight is decreased in the other region, a variable-length code table of higher compression efficiency can be generated. FIG. 18 shows a flow of generating a variable-length code table based on a weighted histogram. The base of the process is the process described with reference to FIG. 3, and the same reference numerals as those in FIG. 3 are designated except for a changed part. In FIG. 18, a region similar to a block to be coded is determined in S18003. To determine a similar region, for example, it is sufficient to obtain the SAD (Sum of Absolute Difference) or SSD (Sum of Square Difference) between a block to be coded and a target block subjected to similarity determination using a local decode image which is already coded, and determine a value equal to or less than an arbitrary threshold as a similar region. Any method may be employed as long as the degree of similarity of blocks is calculated. It is also possible to determine a similar region using the magnitude of the difference of motion vectors or the difference of quantized parameters as a reference. After determining the similar region, a weighted histogram of the MB type is generated (S18004).

After determining the similar region by the coding apparatus, information of the similar region has to be sent to the decoding apparatus. As a sending method, a block address of the similar region may be directly sent, or the similar region is approximated to a rough rectangular region and only information of the start point, height, and width of the rectangle may be sent. Another method of describing region information may be also used.

The decoding apparatus receives information of the similar region and performs processes similar to those performed by the coding apparatus. In such a manner, the same variable-length code table can be generated by the decoding apparatus.

In the foregoing third embodiment, by weighting a region similar to a block to be coded, the possibility that a shorter code is assigned to information of the block to be coded becomes high, and the compression rate can be increased.

«Fourth Embodiment»

A fourth embodiment of the present invention will be described with reference to FIGS. 20 to 22. The reference range for generating a histogram has not be mentioned fixedly in the first to third embodiments. In the fourth embodiment, a reference range is adaptively selected or weighted on the basis of the degree of similarity of histograms of two regions. In the embodiment, configurations similar to those of the image coding apparatus shown in FIGS. 1 and 16 and the image decoding apparatus shown in FIG. 11 are applied. The detailed description of the same configuration and functions will not be repeated. Only different points will be described in detail.

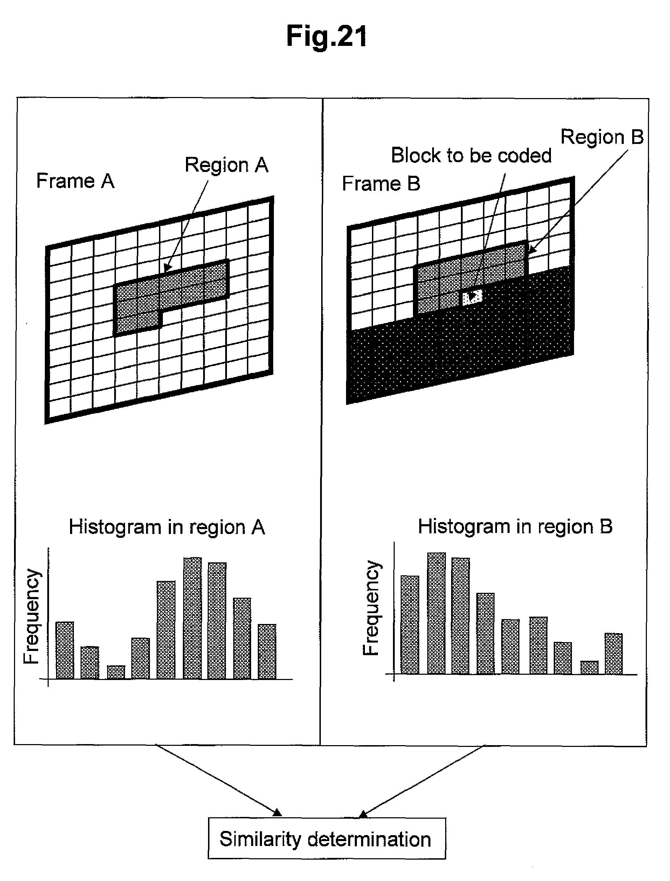

FIG. 20 shows the flow of processes performed by the variable-length code table generating unit 213 in the embodiment. First, in the embodiment, as shown in FIG. 21, regions A and B are set in different frames. For example, it is assumed that the region A is a region near a block to be coded in a past frame, and the region B is a region near a block to be coded in a present frame. The regions A and B may be set differently. For example, the region A may be set as a region near a block to be coded in a future frame, and the region B may be set as a region near a block to be coded in a present frame. A past frame and a future frame in this case do not refer to a coding order but an image display order. After that, a histogram of the MB type in the region A and that of the MB type in the region B are generated. The degree of similarity of the histograms of the two regions (the regions A and B) is calculated (S20001). For example, the similarity degree p is calculated by a Bhattacharyya coefficient shown by mathematical expression 2. Mathematical expressions 3 to 5 are expressions for describing the mathematical expression 2.

$$\rho(\mathbf{p},\mathbf{q}) = \sum_{u=1}^{m} \sqrt{p_u q_u} \qquad \text{... mathematical expression 2}$$

$$\mathbf{p} = \{p_u\}_{u=1\ldots m} \qquad \text{... mathematical expression 3}$$

$$\mathbf{q} = \{q_u\}_{u=1\ldots m} \qquad \text{... mathematical expression 4}$$

$$\sum_{u=1}^{m} q_u = \sum_{u=1}^{m} p_u = 1 \qquad \text{... mathematical expression 5}$$

Here, p in the mathematical expression 3 indicates a histogram of the MB type in the region A, and q in the mathematical expression 4 indicates a histogram of the MB type in the region B. The relation of the mathematical expression 5 is satisfied, and m denotes the number of bits of the MB type. The higher the degree of similarity is, the larger the value of the similarity degree p becomes. When the values coincide, 1 is derived. The degree of similarity may be obtained not only by the Bhattacharyya coefficient but also by a histogram intersection shown in the following mathematical expression 6 or by using another method.

$$\rho(\mathbf{p},\mathbf{q}) = \sum_{u=1}^{m} \min(p_u, q_u) \qquad \text{... mathematical expression 6}$$

Based on the similarity degree p obtained as described above and a threshold comparison result, the reference range is set (S20002). When the similarity degree p is smaller than the threshold, the correlation between frames is regarded as low, and a reference range is set from a present frame (S20003). That is, the reliability of information in the present frame is regarded as high. When the similarity degree p is larger than the threshold, the correlation between frames is regarded as high, and a reference range is set from frames including not only the present frame but also the past frame (S20004). That is, the reliability of information in not only the present frame but also in the past frame is similarly regarded as high. In step S20004, a reference range may be set not only from a past frame but also from a future frame.

Next, regarding only an MB type which can be used in the reference range which is set by the above-described means as a valid mode, a base table for generating a histogram is generated (S20005). After that, the histogram of the MB type in the reference range is generated (S20006), and a variable-length code table is generated in a manner similar to the first to third embodiments (S20007).

By adding the procedure using the initial histogram described in FIG. 3 to the process of FIG. 20, for example, a procedure of FIG. 22 can be employed. Steps S22001 to S22005 in FIG. 22 correspond to steps S20001 to S20005, respectively. Steps S22006 to S22010 in FIG. 22 correspond to steps S3002 to S3006 in FIG. 3, respectively.

Although the process of adaptively selecting a reference range is described as an example in the process of FIG. 20, the process may be replaced with a process of setting weight on a reference range. For example, when the similarity degree p is smaller than the threshold in the determination result in step S20001, the weight on an arbitrary reference region in a present frame is increased. When the similarity degree p is larger than the threshold, the weight on an arbitrary reference region in a past frame is increased. This is not limited to the embodiment but may be also applied to the following embodiments. Although the MB type is described as an example in FIG. 20, a similar procedure may be applied to a CBP parameter as a target.

In the above-described fourth embodiment, by obtaining the correlation of frames by the similarity degree of histograms, a variable-length code table in which the appearance probability of the MB type or the CBP parameter in a block to be coded is reflected more suitably can be generated. Accordingly, the compression rate can be further increased. The detailed description will not be given. Obviously, the technical matters described in the fourth embodiment can be applied also to the decoding apparatus and the decoding method.

«Fifth Embodiment»

A fifth embodiment of the present invention will be described with reference to FIG. 23. The reference range for generating a histogram has not been mentioned fixedly in the first to third embodiments. In the fifth embodiment, a reference range is adaptively selected or weighted on the basis of a motion vector, for example, a representative value of the motion vectors. In the embodiment, configurations similar to those of the image coding apparatus shown in FIGS. 1 and 16 and the image decoding apparatus shown in FIG. 11 are applied. The detailed description of the same configuration and functions will not be repeated. Only different points will be described in detail.

FIG. 23 shows the flow of processes performed by the variable-length code table generating unit 213 in the embodiment. First, an average value of motion vectors in MBs in a reference range in a present frame is obtained and used as a representative value of the motion vectors (S23001). A median, a mode, or the like, not an average value, may be used as a representative value. The representative value of the motion vectors obtained and a threshold are compared (S23002) and a reference range is set on the basis of the comparison result. When the representative value of the motion vectors is larger than the threshold, an arbitrary region in a present frame is set as the reference range (S23003). When the representative value of the motion vector is smaller than the threshold, an arbitrary region in a past, future, or present frame is set as the reference range (S2300). In step S23004, for example, a modification such that a reference range is set from past and present frames, from only a past frame, or from past and future frames can be employed. The following steps S20005 to S20007 are similar to the processes in FIG. 20. The same reference numerals are designated, and their detailed description will not be repeated.

The processes (S2200 to S22010) using the initial histogram may be added also to the process flow of FIG. 23 in a manner similar to FIG. 22.

In the fifth embodiment as described above, by obtaining the correlation of frames by the representative value of motion vectors, a variable-length code table in which the appearance probability of the MB type or the CBP parameter in a block to be coded is reflected more suitably can be generated. It is based on a phenomenon such that when the motion vector is small, a spatial distribution of the MB type or CBP parameter does not largely change in past and future frames. Accordingly, the compression rate can be further increased. The detailed description will not be given. Obviously, the technical matters described in the fifth embodiment can be applied also to the decoding apparatus and the decoding method.

«Sixth Embodiment»

A sixth embodiment of the present invention will be described with reference to FIG. 24. In the sixth embodiment, a reference range is corrected by a representative value of motion vectors in an arbitrary region. In the embodiment, configurations similar to those of the image coding apparatus shown in FIGS. 1 and 16 and the image decoding apparatus shown in FIG. 11 are applied. The detailed description of the same configuration and functions will not be repeated. Only different points will be described in detail.

FIG. 24 conceptually shows the correcting process by the variable-length code table generating unit 213 in the embodiment. In a manner similar to the fifth embodiment of FIG. 23, a representative vector is obtained in the reference range in a present frame. When a reference range is set from a past or future frame in step S23004 in FIG. 23, the reference range in a past frame or future frame is corrected on the basis of the obtained representative vector. That is, the reference range in the past frame or future frame is moved only by the representative vector, and the moved reference range is used. The point that the reference range in the past frame or future frame is moved by using the representative vector, and the moved reference range is used can be also applied to the other embodiments.

In the sixth embodiment as described above, by correcting the reference range by the representative value of motion vectors, a variable-length code table in which the appearance probability of the MB type or the CBP parameter in a block to be coded is reflected more suitably can be generated. Accordingly, the compression rate can be further increased. The detailed description will not be given. Obviously, the technical matters described in the sixth embodiment can be applied also to the decoding apparatus and the decoding method.

«Seventh Embodiment»

A seventh embodiment of the present invention will be described with reference to FIG. 25. In the seventh embodiment, variable-length coding is performed using a specific block as a reference range on the basis of a result of the variable-length coding in a past coded frame. In the embodiment, configurations similar to those of the image coding apparatus shown in FIGS. 1 and 16 and the image decoding apparatus shown in FIG. 11 are applied. The detailed description of the same configuration and functions will not be repeated. Only different points will be described in detail.

FIG. 25 illustrates the correct answer rate as a result of the variable-length coding in a past coded frame. As shown in FIG. 25, the correct answer rate is given to each block. The correct answer rate is obtained by calculating whether the MB type or CBP parameter of each block could be written within the pre-set number of bits or not in past coded frames. That is, in the image display order, a future frame may be also included.

It is assumed that, in a result of variable-length coding of the MB type in a block, code lengths required for describing the MB type of past five frames coded are bit lengths of 5, 1, 1, 3, and 1. In the case of defining that description of three bits or less is a correct answer, the correct answer rate in the block is 4/5. The number of frames in which the correct answer rate can be varied, and an arbitrary value of one past frame can be set. It is sufficient to describe the number of frames used for calculation of a correct answer rate as a syntax element (correct answer rate calculation width) in a coded stream.

In the embodiment, using only a block in which the correct answer rate calculated as described above becomes the threshold Thd or larger as the reference range, the variable-length coding on the MB type or CBP parameter is performed. It is also possible to generate a weighted histogram in accordance with the correct answer rate.

In the seventh embodiment described above, by generating a variable-length code table in accordance with the correct answer rate in past coded frames, a variable-length code table in which the appearance probability of the MB type or the CBP parameter in a block to be coded is reflected more suitably can be generated. Accordingly, the compression rate can be further increased. By adaptively selecting the reference range in the same rule using a syntax element (correct answer rate calculation width) commonly by the coding apparatus and the decoding apparatus, without transmitting an additional bit, higher compression can be realized. The detailed description will not be given. Obviously, the technical matters described in the seventh embodiment can be applied also to the decoding apparatus and the decoding method.

Although the invention achieved by the inventors of the present invention has been concretely described on the basis of the embodiments, obviously, the invention is not limited to the embodiments but can be variously modified without depart from the gist.

INDUSTRIAL APPLICABILITY

For example, the present invention can be applied not only to the motion image coding/decoding technique conformed to the H.264/AVC standard but also widely to the image process technique by the other methods.

Although a block size of 16 pixels by 16 pixels at maximum has been described above as an example, the invention can be also applied to block sizes of 32 pixels by 32 pixels, 64 pixels by 64 pixels, or larger, and variable-length coding on block sizes of 32 pixels by 16 pixels, 64 pixels by 32 pixels, and the like.

The variable-length coding according to the present invention can be applied not only to the MB type but also to a sub-MB type.

EXPLANATION OF REFERENCE NUMERALS

| | |
|---|---|
| 201 | original image memory |
| 202 | subtractor |
| 203 | orthogonal transformer |
| 204 | quantizer |
| 205 | variable-length coding unit |

206     inverse quantizer
207     inverse orthogonal transformer
208     adder
209     frame memory
210     prediction unit
211     prediction mode selector
212     statistical information storing memory
213     variable-length code table generating unit
1101    variable-length decoding unit
1102    statistical information storing memory
1103    variable-length decode table generating unit
1104    inverse quantizer
1105    inverse orthogonal transformer
1106    adder
1107    frame memory
1108    prediction image generating unit

## Claims

1.  An image decoding method of decoding data which is variable-length coded, comprising:

    a first process of storing statistical information of decoded image data into a memory;
    a second process of generating a variable-length decode table on the basis of the statistical information stored in the memory; and
    a third process of performing variable-length decoding on the basis of the variable-length decode table generated in the second process,
    wherein the second process is a process of generating a variable-length decode table by adding occurrence probability of statistical information calculated within a predetermined range of the decoded image data and initial occurrence probability selected on the basis of a decoding parameter, and assigning a short code in descending order of statistical information obtained by the addition.

2.  The image decoding method according to claim 1, wherein in the variable-length decode table generating process, the occurrence probability is generated by adding a weight according to the degree of influence on an object to be decoded, to information calculated in the predetermined range of the coded image data.

3.  The image decoding method according to claim 1, wherein the statistical information is of a macro block type or is a coded block pattern parameter.

4.  The image decoding method according to claim 1, wherein in the variable-length decode table generating process, a reference range specified by a syntax element in stream information to be decoded is set to a range of image data for calculating occurrence probability of the statistical information.

5.  The image decoding method according to claim 1, wherein in the variable-length decode table generating process, whether statistical information which can be referred to at the time of calculating the occurrence probability of the statistical information satisfies preliminarily-set statistics length or not is determined, and when the statistics length is not satisfied, a predetermined variable-length decode table is selected and set to be usable and, when the statistics length is satisfied, a variable-length decode table is generated on the basis of the occurrence probability of the statistical information calculated in the predetermined range.

6.  An image decoding method of decoding data which is variable-length coded, comprising:

    a first process of storing statistical information of decoded image data into a memory;
    a second process of generating a variable-length decode table on the basis of the statistical information stored in the memory; and
    a third process of performing variable-length decoding on the basis of the variable-length decode table generated in the second process,
    wherein the second process is a process of generating a variable-length decode table by selecting a code used for a variable-length decode table in accordance with the proportion of statistical information of high occurrence probability on entire statistical information calculated within a predetermined range of the decoded image data and assigning a short code in descending order of the calculated statistical information of the high occurrence probability.

7. An image decoding method of decoding data which is variable-length coded, comprising:

a first process of storing statistical information of decoded image data into a memory;
a second process of generating a variable-length decode table on the basis of the statistical information stored in the memory; and
a third process of performing variable-length decoding on the basis of the variable-length decode table generated in the second process,
wherein the second process is a process of generating a variable-length decode table by determining whether statistical information which can be referred to at the time of calculating occurrence probability of statistical information satisfies preliminarily-set statistics length or not, and when the statistics length is not satisfied, selecting a predetermined variable-length decode table and setting it to be usable and, when the statistics length is satisfied, assigning a short code in descending order of the calculated statistical information of the high occurrence probability on the basis of the occurrence probability of the statistical information calculated within a predetermined range.

8. An image decoding method of decoding data which is variable-length coded, comprising:

a first process of storing statistical information of decoded image data into a memory;
a second process of generating a variable-length decode table on the basis of the statistical information stored in the memory; and
a third process of performing variable-length decoding on the basis of the variable-length decode table generated in the second process,
wherein the second process is a process of determining the degree of similarity of histograms on occurrence probability of statistical information calculated in a plurality of positions in decoded image data, determining a predetermined range for calculating the occurrence probability in accordance with the degree of similarity, and generating a variable-length decode table on the basis of the occurrence probability of the statistical information calculated in the determined predetermined range.

9. The image decoding method according to claim 8, wherein in the second process, when the degree of similarity of the histograms is smaller than a threshold, a predetermined range for calculating occurrence probability is determined in a present frame and, when the degree of similarity of the histograms is larger than a threshold, a predetermined range for calculating the occurrence probability is determined in a past or future frame.

10. The image decoding method according to claim 8, wherein in the second process, a process of generating a variable-length decode table is performed by adding occurrence probability of statistical information calculated in the determined predetermined range of decoded image data and initial occurrence probability selected on the basis of a decode parameter, and assigning a short code in descending order of statistical information of high occurrence probability obtained by the addition.

11. An image decoding method of decoding data which is variable-length coded, comprising:

a first process of storing statistical information of decoded image data into a memory;
a second process of generating a variable-length decode table on the basis of the statistical information stored in the memory; and
a third process of performing variable-length decoding on the basis of the variable-length decode table generated in the second process,
wherein the second process is a process of generating a variable-length decode table by generating a motion vector in a predetermined range of a block to be decoded in a present frame of the decoded image data, determining a predetermined range for calculating occurrence probability on the basis of the generated motion vector, and assigning a short code in descending order of statistical information of the occurrence probability of the statistical information in the predetermined range.

12. The image decoding method according to claim 11, wherein in the second process, when the generated motion vector is larger than a threshold, a variable-length decode table is generated by assigning a short code in descending order of statistical information of high occurrence probability of the statistical information in the predetermined range in a present frame and, when the generated motion vector is smaller than a threshold, a variable-length decode table is generated by assigning a short code in descending order of statistical information of high occurrence probability in a predetermined range in a past or future frame.

13. The image decoding method according to claim 12, wherein in the second process, when the generated motion vector is smaller than a threshold, by correcting a predetermined range in a past or future frame by the generated motion vector and assigning a short code in descending order of statistical information of high occurrence probability of the statistical information in the corrected predetermined range, a variable-length decode table is generated.

14. An image decoding method of decoding data which is variable-length coded, comprising:

a first process of storing statistical information of decoded image data into a memory;
a second process of generating a variable-length decode table on the basis of the statistical information stored in the memory; and
a third process of performing variable-length decoding on the basis of the variable-length decode table generated in the second process,
wherein the second process is a process of generating a variable-length decode table by assigning a short code in descending order of statistical information of the occurrence probability of the statistical information in the predetermined range in which the number of bits of a code to be variable-length decoded in a past frame is predetermined number of bits or less.

15. An image decoding apparatus for decoding data which is variable-length coded, comprising:

a memory for storing statistical information of decoded image data;
a variable-length decode table generating unit for generating a variable-length decode table on the basis of the statistical information stored in the memory; and
a variable-length decoding unit for performing variable-length decoding on the basis of the variable-length decode table generated by the variable-length decode table generating unit,
wherein the variable-length decode table generating unit generates a variable-length decode table by adding occurrence probability of statistical information calculated within a predetermined range of the decoded image data and initial occurrence probability selected on the basis of a decoding parameter, and assigning a short code in descending order of statistical information obtained by the addition.

16. An image decoding apparatus of decoding data which is variable-length coded, comprising:

a memory for storing statistical information of decoded image data;
a variable-length decode table generating unit for generating a variable-length decode table on the basis of the statistical information stored in the memory; and
a variable-length decoding unit for performing variable-length decoding on the basis of the variable-length decode table generated by the variable-length decode table generating unit,
wherein the variable-length decode table generating unit generates a variable-length decode table by selecting a code used for a variable-length decode table in accordance with the proportion of statistical information of high occurrence probability on statistical information calculated within a predetermined range of the decoded image data and assigning a short code in descending order of the calculated statistical information of the high occurrence probability.

17. An image coding method of compressing quantized data by variable-length coding, comprising:

a first process of storing statistical information of coded image data into a memory;
a second process of generating a variable-length code table on the basis of the statistical information stored in the memory; and
a third process of performing variable-length coding on the basis of the variable-length code table generated in the second process,
wherein the second process is a process of generating a variable-length code table by adding occurrence probability of statistical information calculated in a predetermined range of coded image data and initial occurrence probability selected on the basis of a coding parameter, and assigning a short code in descending order of statistical information of high occurrence probability obtained by the addition.

18. An image coding method of compressing quantized data by variable-length coding, comprising:

a first process of storing statistical information of coded image data into a memory;
a second process of generating a variable-length code table on the basis of the statistical information stored in the memory; and
a third process of performing variable-length coding on the basis of the variable-length code table generated in the second process,
wherein the second process is a process of generating a variable-length code table by selecting a code used for a variable-length code table in accordance with the proportion of statistical information of high occurrence probability on statistical information calculated within a predetermined range of the coded image data and assigning a short code in descending order of the calculated statistical information of the high occurrence probability.

19. An image coding method of compressing quantized data by variable-length coding, comprising:

a first process of storing statistical information of coded image data into a memory;
a second process of generating a variable-length code table on the basis of the statistical information stored in the memory; and
a third process of performing variable-length coding on the basis of the variable-length code table generated in the second process,
wherein the second process is a process of generating a variable-length code table by determining whether or not statistical information which can be referred to at the time of calculating occurrence probability of statistical information satisfies preliminarily-set statistics length, and when the statistics length is not satisfied, selecting a predetermined variable-length code table and setting it to be usable and, when the statistics length is satisfied, assigning a short code in descending order of the statistical information of the high occurrence probability on the basis of the occurrence probability of the statistical information calculated in a predetermined range.

20. An image coding method of compressing quantized data by variable-length coding, comprising:

a first process of storing statistical information of coded image data into a memory;
a second process of generating a variable-length code table on the basis of the statistical information stored in the memory; and
a third process of performing variable-length coding on the basis of the variable-length code table generated in the second process,
wherein the second process is a process of determining the degree of similarity of a histogram on occurrence probability of statistical information calculated in a plurality of positions in coded image data, determining a predetermined range for calculating the occurrence probability in accordance with the degree of similarity, and generating a variable-length code table on the basis of the occurrence probability of the statistical information calculated in the determined predetermined range.

21. The image coding method according to claim 20, wherein in the second process, when the degree of similarity of the histogram is smaller than a threshold, a predetermined range for calculating occurrence probability is determined in a present frame and, when the degree of similarity of the histogram is larger than a threshold, a predetermined range for calculating the occurrence probability is determined in a past or future frame.

22. The image coding method according to claim 21, wherein the second process is a process of generating a variable-length code table by adding occurrence probability of statistical information calculated in the determined predetermined range of coded image data and initial occurrence probability selected on the basis of a decode parameter, and assigning a short code in descending order of statistical information of high occurrence probability obtained by the addition.

23. An image coding method of coding quantized data, comprising:

a first process of storing statistical information of coded image data into a memory;
a second process of generating a variable-length code table on the basis of the statistical information stored in the memory; and

a third process of performing variable-length coding on the basis of the variable-length code table generated in the second process,

wherein the second process is a process of generating a variable-length code table by generating a motion vector in a predetermined range of a block to be coded in a present frame of the coded image data, determining a predetermined range for calculating occurrence probability on the basis of the generated motion vector, and assigning a short code in descending order of statistical information of the occurrence probability of the statistical information in the predetermined range.

24. The image coding method according to claim 23, wherein in the second process, when the generated motion vector is larger than a threshold, a variable-length code table is generated by assigning a short code in descending order of statistical information of high occurrence probability of the statistical information in the predetermined range in a present frame and, when the generated motion vector is smaller than a threshold, a variable-length code table is generated by assigning a short code in descending order of statistical information of high occurrence probability in a predetermined range in a past or future frame.

25. The image coding method according to claim 24, wherein in the second process, when the generated motion vector is smaller than a threshold, by correcting a predetermined range in a past or future frame by the generated motion vector and assigning a short code in descending order of statistical information of high occurrence probability of the statistical information in the corrected predetermined range, a variable-length code table is generated.

26. An image coding method of compressing quantized data by variable-length coding, comprising:

a first process of storing statistical information of coded image data into a memory;
a second process of generating a variable-length code table on the basis of the statistical information stored in the memory; and
a third process of performing variable-length coding on the basis of the variable-length code table generated in the second process,
wherein the second process is a process of generating a variable-length code table by assigning a short code in descending order of statistical information of the occurrence probability of the statistical information in the predetermined range in which the number of bits of a code to be variable-length coded in a past frame is predetermined number of bits or less.

# Fig.1

EP 2 330 825 A1

# Fig.2

|  | MB type | Mode number |
|---|---|---|
| P, SP slice | P_L0_16x16 | 0 |
|  | P_L0_L0_16x8 | 1 |
|  | P_L0_L0_8x16 | 2 |
|  | P_8x8 | 3 |
|  | P_8x8ref0 | 4 |
| I slice | I_NxN | 0 |
|  | I_16x16_0_0_0 | 1 |
|  | : | : |
|  | : | : |
|  | I_16x16_3_2_1 | 24 |
| B slice | B_Direct_16x16 | 0 |
|  | : | : |
|  | : | : |
|  | : | : |
|  | B_8x8 | 22 |

# Fig.3

```
                    ┌─────────────┐
                    │    Start    │
                    └─────────────┘
                           │
                           ▼
        ┌──────────────────────────────┐
        │  set MB type which can be     │────  S3001
        │  used in reference range      │
        └──────────────────────────────┘
                           │
                           ▼
                    ◇─────────────◇
                   ╱ initial histogram ╲────  S3002
                   ╲     set?         ╱         NO ──────────┐
                    ◇─────────────◇                          │
                           │ YES                             │
                           ▼                                 ▼
        ┌──────────────────────┐           ┌──────────────────────────┐
        │ generate histogram of │── S3004  │   set initial histogram  │── S3003
        │ MB type               │          └──────────────────────────┘
        └──────────────────────┘                          │
                           │                               │
                           ▼                               │
        ┌──────────────────────┐                           │
        │  update set initial   │── S3005                   │
        │  histogram            │                           │
        └──────────────────────┘                           │
                           │◄──────────────────────────────┘
                           ▼
        ┌──────────────────────────────┐
        │ generate variable-length code │── S3006
        │ table on the basis of histogram│
        └──────────────────────────────┘
                           │
                           ▼
                    ┌─────────────┐
                    │     End     │
                    └─────────────┘
```

# Fig.4

Initial histogram 1

Frequency

MB type

Initial histogram 2

Frequency

MB type

# Fig.5A

# Fig.5B

# Fig.6

Coded MB

N slices

Block to be coded

Reference range

# Fig.7

Reference range

Block to be coded

# Fig.8

Reference range

Reference range

Block to be coded

Time

# Fig.9

| 1 | 3 | 1 |
|---|---|---|
| 3 | 5 | 3 |
| 1 | 3 | 1 |

# Fig.10

| MB type | Appearance frequency | Mode number (conventional technique) | Mode number (statistical information is considered) |
|---|---|---|---|
| P_L0_16x16 | 15 | 0 | 2 |
| P_L0_L0_16x8 | 5 | 1 | 4 |
| P_L0_L0_8x16 | 20 | 2 | 1 |
| P_8x8 | 30 | 3 | 0 |
| P_8x8ref0 | 10 | 4 | 3 |

# Fig.11

EP 2 330 825 A1

## Fig.12

| CodedBlockPatternLuma | Appearance frequency | codeNum (conventional technique) | codeNum (statistical information is considered) |
|---|---|---|---|
| 0000 | 15 | 0 | 2 |
| 0001 | 5 | 1 | 5 |
| 0010 | 7 | 2 | 4 |
| 0011 | 30 | 4 | 1 |
|  | 40 | 8 | 0 |
| : | : | : | : |
| 1111 | 10 | 15 | 3 |

## Fig.13A

| Sequence header | Picture header #0 | Slice header #0 | Slice data #0 | ........ |
|---|---|---|---|---|

| .... | Reference unit | Reference range width | Reset parameter | ......... |
|---|---|---|---|---|

## Fig.13B

| Sequence header | Picture header #0 | Slice header #0 | Slice data #0 | ........ |
|---|---|---|---|---|

| .... | Reference unit | Reference range width | Reset parameter | ......... |
|---|---|---|---|---|

# Fig.13C

| Sequence header | Picture header #0 | Slice header #0 | Slice data #0 | ········ |
|---|---|---|---|---|

| .... | Reference unit | Reference range width | Reset parameter | ········ |
|---|---|---|---|---|

# Fig.14

```
                    Start

        ┌──────────────────────┐
        │ set MB type which can be │ ⟋ S4001
        │ used in reference range │
        └──────────────────────┘

              ◇ statistics length ◇ ⟋ S4002
                sufficient?          NO
                    YES

   ┌──────────────────┐         ┌──────────────────────┐
   │ generate histogram │ ⟋ S4004 │ select variable-length │ ⟋ S4003
   │ of MB type        │         │ code table which is    │
   └──────────────────┘         │ defined in advance     │
                                └──────────────────────┘
   ┌──────────────────────┐
   │ generate variable-length │ ⟋ S4005
   │ code table on the basis of │
   │ histogram              │
   └──────────────────────┘

                    End
```

# Fig.15

Reference range

Block to be coded

# Fig.17

| MB type+ CodedBlockPatternLuma | Appearance frequency | codeNum (statistical information is considered) |
|---|---|---|
| P_L0_16x16_0000 | 15 | 2 |
| P_L0_16x16_0001 | 5 | 4 |
| : | : | : |
| P_L0_16x16_1111 | 10 | 3 |
| P_L0_L0_16x8_0000 | 18 | 1 |
| P_L0_L0_16x8_0001 | 2 | 5 |
| : | : | : |
| P_L0_L0_16x8_1111 | 1 | 6 |

## Fig.16

# Fig.18

```
                    ┌─────────────┐
                    │    Start    │
                    └─────────────┘
                           │
                           ▼
              ┌──────────────────────────┐
              │ set MB type which can be │ ── S3001
              │ used in reference range  │
              └──────────────────────────┘
                           │
                           ▼
                  ◇─────────────────◇ ── S3002
                  │ initial histogram set? ├─────────────┐
                  ◇─────────────────◇              NO   │
                        │ YES                             │
                        ▼                                 ▼
              ┌──────────────────────┐ ── S18003  ┌──────────────────────┐
              │ determine similar block │          │ set initial histogram │ ── S3003
              └──────────────────────┘            └──────────────────────┘
                        │                                 │
                        ▼                                 │
              ┌──────────────────────┐ ── S18004         │
              │  generate weighted    │                   │
              │  histogram of MB type │                   │
              └──────────────────────┘                   │
                        │                                 │
                        ▼                                 │
              ┌──────────────────────┐ ── S3005          │
              │ update set initial histogram │            │
              └──────────────────────┘                   │
                        │◄────────────────────────────────┘
                        ▼
              ┌──────────────────────────┐ ── S3006
              │ generate variable-length code │
              │ table on the basis of histogram │
              └──────────────────────────┘
                        │
                        ▼
                 ┌─────────────┐
                 │     End     │
                 └─────────────┘
```

# Fig.19

Code length

Code table A

Code table B

Code table C

Mode number of MB type

# Fig.20

Start

calculate histogram similarity between regions A and B — S20001

similarity < threshold — S20002

NO

YES

set reference range from present frame

S20003

set reference range from past/future/present frame — S20004

set MB type which can be used in reference range — S20005

generate histogram of MB type — S20006

generate variable-length code table on the basis of histogram — S20007

End

# Fig.21

# Fig.22

Start

calculate similarity
between regions A and B — S22001

similarity < threshold — S22002

NO → set reference range from
past/future/present frame — S22004

YES

S22003 — set reference range
from present frame

set MB type which can be
used in reference range — S22005

initial histogram set? — S22006

NO → set initial histogram — S22009

YES

generate histogram
of MB type — S22007

update set initial histogram — S22008

generate variable-length code
table on the basis of histogram — S22010

終了

# Fig.23

```
              ┌─────────────┐
              │    Start     │
              └──────┬──────┘
                     │
                     ▼
         ┌───────────────────────┐
         │ calculate representative│ ── S23001
         │ value of motion vectors │
         └───────────┬───────────┘
                     │
                     ▼
              ◇───────────────◇
            ◇  representative   ◇  ── S23002
          ◇ value of motion      ◇──── NO
            ◇ vectors < threshold◇
              ◇───────────────◇
                     │
                    YES
```

representative value of motion vectors < threshold

set reference range from present frame   S23003

set reference range from past/future/present frame   S23004

set MB type which can be used in reference range   S20005

generate histogram of MB type   S20006

generate variable-length code table on the basis of histogram   S20007

End

# Fig.24

Past/future frame          Present frame

# Fig.25

High correct answer rate (threshold Thd or larger)

Low correct answer rate (threshold Thd or less)

## INTERNATIONAL SEARCH REPORT

| International application No. |
| --- |
| PCT/JP2009/002976 |

A.　CLASSIFICATION OF SUBJECT MATTER
H04N7/26(2006.01)i, H03M7/42(2006.01)i

According to International Patent Classification (IPC) or to both national classification and IPC

B.　FIELDS SEARCHED

Minimum documentation searched (classification system followed by classification symbols)
H04N7/24-7/68, H03M7/30-7/50

Documentation searched other than minimum documentation to the extent that such documents are included in the fields searched
　　Jitsuyo Shinan Koho　　　　　1922-1996　　Jitsuyo Shinan Toroku Koho　　1996-2009
　　Kokai Jitsuyo Shinan Koho　　1971-2009　　Toroku Jitsuyo Shinan Koho　　1994-2009

Electronic data base consulted during the international search (name of data base and, where practicable, search terms used)

C.　DOCUMENTS CONSIDERED TO BE RELEVANT

| Category* | Citation of document, with indication, where appropriate, of the relevant passages | Relevant to claim No. |
| --- | --- | --- |
| A | JP 10-322222 A  (Nippon Telegraph And Telephone Corp.), 04 December, 1998 (04.12.98), Full text; all drawings (Family: none) | 1-26 |
| A | JP 11-340838 A  (Fuji Xerox Co., Ltd.), 10 December, 1999 (10.12.99), Par. No. [0012] & US 6188338 B1 | 1-26 |
| A | JP 2003-324731 A  (Sony Corp.), 14 November, 2003 (14.11.03), Full text; all drawings (Family: none) | 1-26 |

☒　Further documents are listed in the continuation of Box C.　　　☐　See patent family annex.

| | |
| --- | --- |
| *　　Special categories of cited documents:<br>"A"　document defining the general state of the art which is not considered　to be of particular relevance<br>"E"　earlier application or patent but published on or after the international filing date<br>"L"　document which may throw doubts on priority claim(s) or which is cited to establish the publication date of another citation or other special reason (as specified)<br>"O"　document referring to an oral disclosure, use, exhibition or other means<br>"P"　document published prior to the international filing date but later than the priority date claimed | "T"　later document published after the international filing date or priority date and not in conflict with the application but cited to understand the principle or theory underlying the invention<br>"X"　document of particular relevance; the claimed invention cannot be considered novel or cannot be considered to involve an inventive step when the document is taken alone<br>"Y"　document of particular relevance; the claimed invention cannot be considered to involve an inventive step when the document is combined with one or more other such documents, such combination being obvious to a person skilled in the art<br>"&"　document member of the same patent family |

| Date of the actual completion of the international search<br>　　14 September, 2009 (14.09.09) | Date of mailing of the international search report<br>　　29 September, 2009 (29.09.09) |
| --- | --- |
| Name and mailing address of the ISA/<br>　　Japanese Patent Office | Authorized officer |
| Facsimile No. | Telephone No. |

Form PCT/ISA/210 (second sheet) (April 2007)

**INTERNATIONAL SEARCH REPORT**

| International application No. |
| --- |
| PCT/JP2009/002976 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 8-51621 A  (Canon Inc.),<br>20 February, 1996 (20.02.96),<br>Full text; all drawings<br>(Family: none) | 1-26 |
| A | JP 2005-528066 A  (General Instrument Corp.),<br>15 September, 2005 (15.09.05),<br>Full text; all drawings<br>& WO 2003/105483 A2     & US 2003/0169816 A1 | 1-26 |
| A | JP 2001-86004 A  (Samsung Electronics Co.,<br>Ltd.),<br>30 March, 2001 (30.03.01),<br>Full text; all drawings<br>& US 6668094 B1        & EO 1075087 A2<br>& KR 10-2001-0016662 A | 1-26 |
| A | JP 2006-33508 A  (Olympus Corp.),<br>02 February, 2006 (02.02.06),<br>Full text; all drawings<br>(Family: none) | 1-26 |
| A | JP 2005-12496 A  (Olympus Corp.),<br>13 January, 2005 (13.01.05),<br>Full text; all drawings<br>(Family: none) | 1-26 |

Form PCT/ISA/210 (continuation of second sheet) (April 2007)

## INTERNATIONAL SEARCH REPORT

| International application No. |
|---|
| PCT/JP2009/002976 |

**Box No. II      Observations where certain claims were found unsearchable (Continuation of item 2 of first sheet)**

This international search report has not been established in respect of certain claims under Article 17(2)(a) for the following reasons:

1. ☐ Claims Nos.:
because they relate to subject matter not required to be searched by this Authority, namely:

2. ☐ Claims Nos.:
because they relate to parts of the international application that do not comply with the prescribed requirements to such an extent that no meaningful international search can be carried out, specifically:

3. ☐ Claims Nos.:
because they are dependent claims and are not drafted in accordance with the second and third sentences of Rule 6.4(a).

**Box No. III      Observations where unity of invention is lacking (Continuation of item 3 of first sheet)**

This International Searching Authority found multiple inventions in this international application, as follows:
See the extra sheet.

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.    Consequently, this international search report is restricted to the invention first mentioned in the claims; it is covered by claims Nos.:

**Remark on Protest**
the

☐ The additional search fees were accompanied by the applicant's protest and, where applicable, payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2007)

| INTERNATIONAL SEARCH REPORT | International application No. |
|---|---|
| | PCT/JP2009/002976 |

Continuation of Box No.III of continuation of first sheet(2)

This international application includes the following invention groups that do not satisfy the requirement of unity of invention.

(1) Inventions of claims 1-5, 15, 17
(2) Inventions of claims 6, 16, 18
(3) Inventions of claims 7, 19
(4) Inventions of claims 8-10, 20-22
(5) Inventions of claims 11-13, 23-25
(6) Inventions of claims 14, 26

The matter common to these invention groups is that "a variable-length decode book (code book) is generated according to statistical information stored in a memory." However, the matter is not novel since it is disclosed in document JP 10-322222 A (Nippon Telegraph And Telephone Corp.), 04 December, 1998 (04.12.98), full text, full drawing, or the like.

Therefore, the above-mentioned matter is not a special technical feature within the meaning of PCT Rule 13.2, second sentence since it makes no contribution over the prior art.

Furthermore, since there exists no other common matter that can be considered as a special technical feature within the meaning of PCT Rule 13.2, second sentence, no technical relationship between these different inventions within the meaning of PCT Rule 13 can be seen.

Consequently, the inventions of claims 1-26 do not satisfy the requirement of unity of invention.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI081996205169 B
- JP HEI101998322222 B